(19) Europäisches Patentamt
European Patent Office
Office européen des brevets

(11) **EP 2 044 487 B1**

(12) **EUROPÄISCHE PATENTSCHRIFT**

(45) Veröffentlichungstag und Bekanntmachung des Hinweises auf die Patenterteilung:
**20.04.2011 Patentblatt 2011/16**

(21) Anmeldenummer: 07786179.7

(22) Anmeldetag: **19.07.2007**

(51) Int Cl.:
***G03F 7/20*** (2006.01)

(86) Internationale Anmeldenummer:
**PCT/EP2007/006407**

(87) Internationale Veröffentlichungsnummer:
**WO 2008/012022 (31.01.2008 Gazette 2008/05)**

(54) **OPTISCHE VORRICHTUNG MIT KORRIGIERTEM BZW. VERBESSERTEM ABBILDUNGSVERHALTEN**

OPTICAL APPARATUS WITH CORRECTED OR IMPROVED IMAGING BEHAVIOUR

DISPOSITIF OPTIQUE AVEC UN COMPORTEMENT D'IMAGE CORRIGÉ RESPECTIVEMENT AMÉLIORÉ

(84) Benannte Vertragsstaaten:
**DE FR NL**

(30) Priorität: **24.07.2006 DE 102006034755**

(43) Veröffentlichungstag der Anmeldung:
**08.04.2009 Patentblatt 2009/15**

(73) Patentinhaber: **Carl Zeiss SMT GmbH
73447 Oberkochen (DE)**

(72) Erfinder:
  • **SCHRIEVER, Martin
    73434 Aalen (DE)**
  • **WEGMANN, Ulrich
    89551 Königsbronn (DE)**
  • **HEMBACHER, Stefan
    86399 Bobingen (DE)**
  • **GEUPPERT, Bernhard
    73430 Aalen (DE)**

  • **HUBER, Jürgen
    89522 Heidenheim (DE)**
  • **KERWIEN, Norbert
    73563 Mögglingen (DE)**
  • **TOTZECK, Michael
    73525 Schwäbisch-Gmünd (DE)**
  • **HAUF, Markus
    89075 Ulm (DE)**

(74) Vertreter: **Heuckeroth, Volker et al
Witte, Weller & Partner
Patentanwälte
Postfach 10 54 62
70047 Stuttgart (DE)**

(56) Entgegenhaltungen:
**WO-A-02/093257     WO-A-2005/109083
DE-A1- 3 205 296    US-A- 4 970 546
US-B1- 6 246 528**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine optische Vorrichtung mit einer Lichtquelle, die Licht in Form von Lichtpulsen mit einer Pulsfrequenz abstrahlt, und mit mindestens einem optischen Element gemäß dem Oberbegriff des Anspruchs 1.

Eine solche Vorrichtung ist aus US-A-4 970 546 bekannt.

Optische Vorrichtungen können im Laufe ihres Betriebs ihre Abbildungseigenschaften aus den verschiedensten Gründen ändern. Durch Alterung können sich beispielsweise Materialeigenschaften ändern, durch Temperaturgradienten oder durch Einfluss mechanischer Kräfte, beispielsweise durch die Fassung, kann es zu Verformungen der optischen Elemente kommen. Werden optische Vorrichtungen über längere Zeit intensiver Strahlung ausgesetzt, kann dies ebenfalls zu Veränderungen der Abbildungseigenschaften führen.

Auch auf kurzen Zeitskalen (Sekunden), beispielsweise hervorgerufen durch Veränderung der eingestrahlten Lichtmengen (Änderung der Beleuchtungseinstellungen oder Änderung der Abbildungsmuster bewirken unterschiedliche Lichtwege und Intensitäten im System), ist mit Veränderungen der Abbildungseigenschaften im Sekundenbereich zu rechnen.

Dies betrifft besonders Projektionsbelichtungsanlagen für die Mikrolithographie. Neben den genannten Alterungserscheinungen kann es bei optischen Elementen aus Quarz, wie sie derzeit häufig eingesetzt werden, unter intensiver UV-Strahlungsbelastung beispielsweise zu einer Änderung der Brechzahl kommen. Auch Beschichtungen der optischen Elemente in einem Objektiv einer Projektionsbelichtungsanlage können unter Bestrahlung oder aufgrund von Kontamination ihre Eigenschaften ändern. All diese Einflüsse tragen zur Änderung der Abbildungseigenschaften im Laufe der Betriebsdauer des Objektivs bei. Häufig ergeben sich dadurch neue Bildfehler oder es werden Bildfehler, die bereits vorhanden waren, verstärkt.

In Objektiven für die Mikrolithographie nimmt man daher bereits beim Design des optischen Systems Rücksicht auf die zu erwartenden Änderungen der Abbildungseigenschaften. Für bestimmte Elemente können Manipulatoren vorgesehen werden, die beispielsweise eine laterale Verschiebung des optischen Elements ermöglichen. Zusammen mit einer Messvorrichtung, zum Beispiel einem Wellenfrontsensor, können somit durch Alterungseffekte oder durch temporäre Effekte wie lokale Erwärmung entstehende Abbildungsfehler gezielt kompensiert werden. Eine solche Verschiebung optischer Elemente in z-Richtung ist beispielsweise in der US-Offenlegungsschrift US 2003/0063268 A1 beschrieben.

Neben dem Einsatz von Manipulatoren ist eine weitere Korrekturmöglichkeit für Abbildungsfehler die gezielt eingebrachte statische Verformung von Linsen- oder Spiegelelementen. Auf diese Weise werden beispielsweise zylindrische, astigmatische/sattelförmige Deformationen eingestellt. Eine entsprechende Vorrichtung ist in DE 198 59 634 A1 beschrieben, die im Laufe der Betriebsdauer des Objektivs entstehende Änderungen der Abbildungseigenschaften eines Projektionsobjektivs durch Erzeugung eines zusätzlichen Astigmatismus kompensiert. Eine ähnliche Vorgehensweise ist in EP 678 768 A2 beschrieben.

Bei beiden Verfahren ist jedoch nur die Korrektur einer begrenzten Anzahl von Bildfehlern möglich. Durch die Verschiebung bestimmter optischer Elemente können lediglich Bildfehler niedriger Ordnung kompensiert werden. Die statische Verformung optischer Elemente erlaubt nur relativ einfache Deformationen und wird überwiegend zur Korrektur des Astigmatismus und/ oder anamorphotischer Verzeichnung, d.h. unterschiedlicher Abbildungsmaßstäbe in zwei orthogonalen Achsen, eingesetzt.

In US 6 198 579 B ist ein Verfahren zur Korrektur von nicht-rotationssymmetrischen Abbildungsfehlern in einem Objektiv beschrieben, bei dem mehrere Peltier-Elemente an zumindest einem der optischen Elemente des Objektivs angeordnet werden, die an seinem Umfang verteilt sind, und die unterschiedlich angesteuert werden, um eine Temperaturverteilung in dem optischen Element zu erzeugen, um so Abbildungsfehler zu korrigieren.

In US 6 521 877 B ist eine optische Anordnung, insbesondere in einer mikrolithografischen Projektionsbelichtungsanlage beschrieben, bei der Abbildungsfehler durch gezieltes Erwärmen optischer Elemente mittels einer Widerstandsheizung kompensiert werden.

Schließlich ist ebenfalls bekannt, Linsenelemente mit einer gezielt zur Korrektur von Abbildungsfehlern des Objektivs vorgesehenen Freiformfläche zu versehen. Ein Beispiel dafür wird in der US 6,268,903 angegeben. Solche Linsenelemente werden als Korrekturasphären bezeichnet. Sie können bereits bei der Justage des Objektivs eingesetzt werden. Es ist auch möglich, im Objektiv austauschbare optische Elemente vorzusehen, die nach einiger Betriebszeit durch Austauschelemente mit einer Freiformfläche ersetzt werden können, deren Form die durch Alterungseffekte entstandenen Abbildungsfehler gerade kompensiert.

Mit Hilfe solcher Freiformflächen können zwar im Prinzip beliebig komplizierte Wellenfrontdeformationen ausgeglichen werden, die Probleme bei der praktischen Umsetzung des Verfahrens sind jedoch vielfältig. Zum einen ist jeder Eingriff in ein bereits in Betrieb genommenes Objektiv unerwünscht, da dieser eine Ruhezeit der Lithographieanlage bedeutet. Zum anderen müssen solche Austauschelemente mit einer gegenüber nicht austauschbaren Elementen deutlich höheren Genauigkeit gefertigt werden. Die Fertigung solcher Austauschelemente ist deshalb sehr aufwändig.

Aus dem eingangs genannten Dokument US-A-4 970 546 ist eine optische Vorrichtung bekannt, mit einem Laser als Lichtquelle, der gepulstes Licht erzeugt, und mit einem Spiegel, der in Synchronisation mit den Lichtpulsen vibriert. Hierdurch soll ein Beleuchtungssystem für eine Projektionsbelichtungsanlage geschaffen werden, die Licht mit verbesserter Homogenität in der Intensität in das Projektionsobjektiv einspeist.

Aus dem Dokument WO 02/093257 A ist eine Projektionsbelichtungsanlage für die Mikrolithographie offenbart. Die dort offenbarte optische Vorrichtung weist eine Lichtquelle, die Licht in Form von Lichtpulsen mit einer Pulsfrequenz abstrahlt, und zumindest ein optisches Element auf, das mittels Vorrichtungen zur Anregung einer Schwingung des optischen Elements verbunden ist. Die Schwingungsfrequenz des optischen Elements ist mit der Pulsfrequenz der Lichtquelle synchronisiert.

Aufgabe der Erfindung ist es, eine optische Vorrichtung, insbesondere eine Projektionsbelichtungsanlage, anzugeben, bei der Bildfehler, die im Laufe der Betriebsdauer entstehen, insbesondere Bildfehler höherer Ordnung, mit möglichst einfachen Mitteln korrigiert werden können.

Diese Aufgabe wird hinsichtlich der eingangs genannten optischen Vorrichtung durch die kennzeichnenden Merkmale des Anspruchs 1 gelöst.

Eine erfindungsgemäße optische Vorrichtung weist eine Lichtquelle, die Licht in Form von Lichtpulsen abstrahlt und ein optisches Element auf, welches mit Vorrichtungen zur Anregung einer Schwingung des optischen Elements verbunden ist, wobei die Schwingung des optischen Elements zu einer zeitlich periodischen Modulation zumindest eines für die optische Abbildung relevanten Parameters des optischen Elements, wie z.B. Brechungsindex, Polarisationseigenschaften, Dichte, Form, Lage oder Winkel, führt, wobei die Schwingungsfrequenz mittels der Vorrichtungen zur Anregung einer Schwingung des optischen Elements so einstellbar ist, dass sie mit der Pulsfrequenz der Lichtquelle oder einer Harmonischen (ganzzahligem Vielfachen der Pulsfrequenz) synchronisiert ist. Ein Taktgeber ist für die Pulsfrequenz der Lichtpulse vorgesehen, wobei mit dem Taktgeber zumindest ein Frequenzvervielfacher verbunden ist, dessen Ausgang mit den Vorrichtungen zur Erzeugung einer Schwingung verbunden ist. Erfindungsgemäß ist unter einer Schwingung des optischen Elements nicht nur eine lokale Ortsauslenkung des optischen Elements, sondern auch Schallwellen, Druckwellen, Dichtewellen usw., die sich innerhalb des optischen Elements ausbreiten, zu verstehen.

Unter einer gepulsten Lichtquelle ist im folgenden jede Art von Lichtquelle zu verstehen, die Licht in Form von einzelnen, zeitlich getrennten Lichtpulsen abgibt, wie beispielsweise ein gepulster Laser, aber auch ein Stroboskop. Dabei wird der Lichtfluss, bzw. die Lichtintensität periodisch variiert. Diese Periodizität kann, wie z. B. bei gepulsten Lasern oder anderen elektronisch schalt- oder steuerbaren Lichtquellen, direkt, beispielsweise durch elektronische Beschaltung, eingestellt werden. Die periodische Lichtmodulation kann jedoch auch durch ein oder mehrere der Lichtquelle nachgelagerte schaltbare Elemente, wie Blenden, Chopperräder, oszillierende Blendensegmente oder elektronisch ansteuerbare Shutter, insbesondere LCD-Shutter, in Transmission oder in Reflexion, zum Beispiel mit einem rotierenden periodisch segmentierten Spiegel, eingestellt werden. Sowohl die Form des Intensitätsprofil des Lichtpulses als auch die Pulslänge und das Tastverhältnis der periodischen Variation kann durch Auswahl der Mittel den Anforderungen angepasst werden. Dies kann zum Beispiel durch Gestaltung der Transmissionseigenschaften von oszillierenden oder rotierenden Blenden geschehen oder durch die Einstellung der Schaltgeschwindigkeit elektronisch steuerbarer Blenden.

Unter einer Synchronisierung zwischen der Pulsfrequenz der Lichtquelle und der Schwingungsfrequenz des optischen Elements ist zu verstehen, dass die Frequenz der periodisch variierten Bestrahlung und die des schwingenden Elementes so aufeinander abgestimmt werden, dass ein für den Abbildungs- bzw. Beleuchtungszweck ausreichend stabiler quasi-statischer Zustand erreicht wird. Bezüglich der Frequenz ist dies der Fall, wenn die Frequenz der Bauteilschwingung ganze Vielfache der Frequenz der Beleuchtung beträgt, so dass gilt

$$\nu_{OE} = N\nu_L \quad \text{mit} \quad N \geq 1,$$

wobei $\nu_{OE}$ die Schwingungsfrequenz des optischen Elements, $\nu_L$ die Pulsfrequenz der Lichtquelle und N eine ganze Zahl repräsentieren.

Aus dem US-Patent US 6,700,952 B2 ist es bekannt, die Oberfläche eines Spiegels in elastische Schwingungen zu versetzen und auf diese Weise eine Gitterstruktur zu erzeugen, so dass einfallendes Licht an dieser Gitterstruktur mit einem bestimmten Winkel gebeugt wird. Durch geeignete Wahl der Schwingungsfrequenz kann dieser Winkel eingestellt werden. Aufgabe der in US 6,700,952 B2 beschriebenen Vorrichtung ist es, durch kontinuierliche Veränderung der Schwingungsfrequenz des Spiegels eine homogene Beleuchtung zu erzeugen. Eine Synchronisation der Schwingungsfrequenz des optischen Elements mit der Pulsfrequenz einer Lichtquelle ist daher nicht vorgesehen und auch nicht erwünscht.

In WO 02/093257 A2 ist eine Projektionsbelichtungsanlage für die Mikrolithographie bzw. ein optisches System beschrieben, bei dem zur Kompensation spannungsdoppelbrechungsinduzierter Abbildungsfehler dynamische Kräfte in zumindest ein optisches Element eingeleitet werden. Die dynamischen Kräfte sind mit einer gepulsten Lichtquelle synchronisiert, so dass zum Zeitpunkt der Beeinflussung des Lichtbündels der Lichtquelle durch das optische Element optimale Abbildungsbedingungen für die Projektion vorherrschen.

Des Weiteren ist es aus dem Dokument DE 100 40 813 A1 bekannt, ein Beugungsgitter als ein Reflektionsgitter mit einer veränderbaren Gitterkonstante auszubilden, wobei die veränderbare Gitterkonstante durch Oberflächenwellen auf einer Oberfläche einer Oberflächenwellen-Bauanordnung erzeugt wird. Das so bereitgestellte Beugungsgitter wird in einem Spektrometer zur Bestimmung der Wellenlänge einer von einer zu vermessenden Strahlungsquelle emittierten Strahlung verwendet.

In einem erfindungsgemäßen Verfahren werden Änderungen der Abbildungseigenschaften der optischen Vorrichtung im Laufe der Betriebsdauer, statt wie im Stand der Technik durch statische Verformung eines optischen Elementes, mit Hilfe eines optischen Elements kompensiert, das in Schwingungen versetzt wird. Durch das in elastische Schwingungen versetzte optische Element kann der Wellenfrontverlauf der Lichtpulse dynamisch korrigiert bzw. gezielt beeinflusst werden, um die Abbildungsqualität der optischen Vorrichtung zu verbessern. Es ist ebenfalls möglich, dass durch das in Schwingungen versetzte optische Element gezielt Verzerrungen des Wellenfrontverlaufs der Lichtpulse induziert werden, die dann das Abbildungsverhalten der optischen Vorrichtungen verbessern.

Zur Kompensation der Änderungen der Abbildungseigenschaften der optischen Vorrichtung wird die Schwingungsfrequenz gemäß der obigen Gleichung so gewählt, dass das optische Element zu jedem Zeitpunkt, an dem ein Lichtpuls auf dieses optische Element auftrifft, so ausgelenkt ist, dass die resultierende Form der optisch aktiven Fläche eine Form aufweist, die eine gewünschte Änderung der Wellenfront bewirkt.

Die Erfindung ist jedoch nicht darauf beschränkt, dass in dem optischen Element Schwingungen angeregt werden, die zu einer Änderung der Form oder der Geometrie des optischen Elements führen, sondern an Stelle von oder zusätzlich zu derartigen transversalen Schwingungen können in einem geeignet dimensionierten optischen Element auch longitudinale Schwingungen angeregt werden, die zu Dichtevariationen, beispielsweise Dehnungen und Stauchungen, im Material des optischen Elements führen. Solche Dichtevariationen gehen mit einer lokalen Änderung des Brechungsindexes einher, d.h. bei Anregung einer longitudinalen Schwingung entstehen im optischen Element Bereiche mit unterschiedlichen Brechungsindizes, durch die die gewünschte optische Wirkung erzielt werden kann. Optische Elemente, die sich zur Anregung longitudinaler Schwingungen besonders eignen, sind gas- oder flüssigkeitsgefüllte optische Elemente, da in diesen Dichtevariationen mit ausgeprägter Amplitude einstellbar sind. Es können auch in optischen Elementen, die als kristalliner oder amorpher Festkörper ausgebildet sind, longitudinale und transversale Schwingungen zur Änderung der Abbildungseigenschaften des optischen Systems angeregt werden.

In dem optischen Element können stehende Schallwellen induziert werden, was zu Druck- oder Dichtevariationen im optischen Element führt. Das optische Element wirkt dabei als Resonanzkörper für die induzierten Schwingungen, dessen Form, Ausdehnung und Materialwahl an die entsprechende zu erzielende Korrekturwirkung der Abbildungsfehler der optischen Vorrichtung angepasst werden kann. Die Schwingungen können sich dabei in zwei oder in drei Dimensionen des optischen Elements ausbreiten. Das hervorgerufene Schallwellenfeld führt zu einer ortsabhängigen Kompression bzw. Dehnung des Materials des optischen Elements, wodurch eine ortsabhängige Änderung des Brechungsindexes des optischen Elements verursacht wird. Je nach Material des optischen Elements kann beispielsweise nur der isotrope Brechungsindex des optischen Elements variiert werden, was zu einer beispielsweise kontinuierlichen Beeinflussung der Wellenfront des Lichtpulses im Sinne einer Grin-Linse führt, der durch das in Schwingungen versetzte optische Element hindurchtritt. Dies ist insbesondere bei Flüssigkeiten niedriger Viskosität oder Gasen der Fall. Ist das Material des optischen Elements hingegen ein amorpher oder kristalliner Festkörper, so kann sich der Schalldruckpegel auch in eine lokale Änderung der Doppelbrechungseigenschaften des optischen Elements umsetzen und das Polarisationsverhalten, d.h. den Polarisationszustand und Polarisationsgrad der Wellenfront des Lichtpulses der Lichtquelle verändern. Auf diese Weise kann das optische Element auch als räumlich variierender polarisationsoptischer Modulator eingesetzt werden, mit dem der Polarisationszustand des Lichtes ortsaufgelöst manipuliert werden kann. Das Verhältnis der skalaren Brechungsindexänderung zur Stärke der induzierten Doppelbrechung kann durch die passende Wahl des Mediums kontrolliert werden.

Neben der Korrektur von skalaren Wellenfrontfehlern von optischen Systemen können so Polarsiationsaberrationen optischer Systeme kompensiert werden. Diese treten zum Beispiel für abbildende Systeme oder auch Beleuchtungssysteme bei kurzen Wellenlängen im DUV auf, da kristalline Festkörper als optische Materialien zum Einsatz kommen, die intrinsische Doppelbrechung (IDB) aufweisen. Die resultierenden Polarisationsaberrationen beeinträchtigen die Abbildungseigenschaften im System und müssen daher korrigiert werden. Kristalle (z.B. $CaF_2$, Quarz aber auch High-Index Materialien wie Spinell oder Luag, $BaF_2$, $BaLiF_3$, LiF) bewirken zum Beispiel in <100> Orientierung primär rotationssymmetrische Abweichung und eine 4-Welligkeit. In <111> liegt ein 3-welliger Aberrationsverlauf vor. Darüber hinaus weisen die auf die Linsen aufgebrachten optischen Schichten (Antireflexschichten etc.) ein doppelbrechendes Verhalten auf. Gründe hierfür sind eine herstellungsbedingte Anisotropie der Schichten durch den Bedampfungsprozess oder auch eingeführte Spannungen in den Vielschichtsystemen. Sie liefern üblicherweise einen rotationssymmetrischen Doppelbrechungsverlauf. Auch die inhomogene Strahlungsbelastung im Betrieb eines Belichtungssystems kann zu lokal induzieren Verspannungen und daher zu Eintragung von Doppelbrechung führen, die einen i.A komplizierten Verlauf aufweisen.

In diesem Zusammenhang ist es in diesem Fall bevorzugt, dass das optische Element als quaderförmige bzw. kreisförmige Platte mit einer geeigneten Kantenlänge bzw. Radius oder auch als Linse ausgestaltet und aus Quarzglas, Kalziumfluorid, Luag oder auch geeigneten doppelbrechenden Flüssigkeiten gefertigt ist.

Da die Schallwelle im optischen Element zeitlich harmonisch oszilliert und die zeitlich gemittelte Brechungsindexänderung verschwindet, ist es weiterhin bevorzugt, dass die Lichtquelle eine entsprechende Triggerung in Form eines Taktgebers, beispielsweise eines optischen Schalters, aufweist, wodurch die Pulsfrequenz und die Schwingungsfrequenz des optischen Elements synchronisiert werden.

Das erfindungsgemäße Verfahren ist nicht nur dazu ausgelegt, Wellenfrontaberrationen zu korrigieren, sondern die Korrekturwirkung kann sich auch auf die Intensitätsverteilung und somit auf den Kontrast der Abbildung bzw. im Fall einer Projektionsbelichtungsanlage auf die Strukturbreite im Lack des Wafers beziehen.

So kann sich beispielsweise die Korrektur auf die Winkelverteilung der Intensität der Beleuchtung beziehen. In einer Projektionsbelichtungsanlage entsprechen die Winkel der Beleuchtung in der Objektebene den Orten der Pupille des Projektionsobjektivs. Damit entspricht die Winkelverteilung der Beleuchtung der Intensitätsverteilung in der Objektivpupille. Die für die Abbildung wichtige Intensitätsverteilung in der Austrittspupille kann unerwünscht variieren, beispielsweise in Form einer statischen Apodisation, beispielsweise durch nichtideale, also nicht über alle Winkel homogen wirkenden Schichten (in der Regel Transmission bei Linsen, Reflektion bei Spiegeln), aber auch durch zeitliche Variation der Schichteigenschaften.

Darüber hinaus kann durch die Kombination eines polarisationsoptischen Modulators im oben beschriebenen Sinne mit weiteren polarisationsoptischen Elementen (insbesondere Polarisatoren) die Intensitätsverteilung räumlich moduliert werden. Durch die geeignete Hintereinanderschaltung der Elemente kann das Transmissionsverhalten des Gesamtelements ähnlich dem Prinzip von Flüssigkeitsdisplays räumlich eingestellt und verändert werden.

Die erfindungsgemäß im Beleuchtungssystem eingesetzten Elemente ermöglichen eine Korrektur bzw. eine Optimierung der Abbildungseigenschaften des Gesamtsystems, die an die individuellen, ggf. auch zeitlich nicht stabilen Transmissionseigenschaften der Optik bei den gewählten Beleuchtungssettings und den abzubildenden Strukturen anpassbar ist. Je nach Struktur durchlaufen die Beugungsordnungen im Projektionsobjektiv unterschiedliche optische Wege und kommen entsprechend den lokalen Transmissionseigenschaften/-variationen mit unterschiedlichen Intensitäten am Bildort zu Überlagerungen/Interferenz. Dementsprechend bestimmen die überlagerten Intensitäten den Kontrast der Abbildung und damit die "Breite" der im Lack abgebildeten Struktur (Schwellwertverhalten des Lacks). Die Gleichheit der abgebildeten Strukturbreiten über das gesamte Bildfeld (CD-uniformity) ist neben der Auflösung eine wichtige Größe.

Gegenüber den aus dem Stand der Technik bekannten Verfahren und Vorrichtungen zur Kompensation von Bildfehlern, die beispielsweise im Laufe des Betriebs eines Projektionsobjektivs entstehen, ergibt sich auf diese Weise eine erheblich höhere Flexibilität für die Bildfehlerkorrektur. Dadurch dass aus einer Vielzahl von Schwingungsmoden des optischen Elements ausgewählt werden kann, lassen sich auch Bildfehler höherer Ordnung kompensieren als bei rein statischer Verformung des optischen Elements, bei der höhere Ordnungen nur mit erheblichem Aufwand kompensiert werden können. Da bei Bedarf zwischen verschiedenen Schwingungsmoden gewechselt werden kann, kann auch der Tatsache Rechnung getragen werden, dass im Laufe des Betriebs eine Änderung der Bildfehler auftritt.

Indem die Schwingungsfrequenz des optischen Elements phasenverschoben zur Pulsfrequenz der Lichtquelle gewählt wird, kann die Stärke der optischen Wirkung in Abhängigkeit des Phasenunterschieds zusätzlich eingestellt werden.

In weiteren bevorzugten Ausgestaltungen wird die Schwingung des optischen Elements als Überlagerung von Schwingungen mit unterschiedlichen ganzzahligen Vielfachen der Pulsfrequenz angeregt, um so periodisch modulierte Abbildungseigenschaften in dem optischen Element einzustellen, die zu einer optischen Wirkung höherer Ordnung führen. Da jede Eigenmode einer Schwingung eines optischen Elements eine nur von der Geometrie des optischen Elements und den Randbedingungen abhängige charakteristische Eigenform hat, kann diese durch die Anregung zwar in ihrer Amplitude und Phase gesteuert werden, nicht jedoch in ihrer Form. Um nun die gewünschte optische Wirkung zu erzielen, kann man mehrere Eigenmoden, deren Eigenfrequenzen ganzzahlige Vielfache der Laserfrequenz sind, mit geeigneter Amplitude oder Phase überlagern, um die gewünschte optische Wirkungsfunktion einzustellen. Mit anderen Worten wird die gewünschte optische Wirkungsfunktion nach Eigenformen der Schwingungsmoden entwickelt, deren Eigenfrequenzen harmonisch zu der Pulsfrequenz sind. Praktischerweise wird man die Geometrie des optischen Elements so auslegen, dass die Eigenformen den benötigten Korrekturfunktionen entsprechen und deren Eigenfrequenzen mit den Harmonischen der Pulsfrequenz zusammenfallen.

In diesem Zusammenhang ist es weiterhin bevorzugt, wenn den unterschiedlichen ganzzahligen Vielfachen der Pulsfrequenz jeweils eine individuelle Phasenverschiebung zugeordnet ist, wobei die Phasenverschiebungen vorzugsweise variabel einstellbar sind, und/oder wenn den unterschiedlichen ganzzahligen Vielfachen der Pulsfrequenz jeweils eine eigene Schwingungsamplitude zugeordnet ist, die ebenfalls vorzugsweise variabel einstellbar ist. Die Phasenverschiebungen und/oder Amplituden, die den unterschiedlichen ganzzahligen Vielfachen der Pulsfrequenz zugeordnet sind, können zueinander und/oder zur Pulsfrequenz unterschiedlich sein. Des weiteren kann es vorteilhaft sein, die zeitliche Phase so zu wählen, dass der Puls am Umkehrpunkt des Oszillationsvorgangs auf das optische Element trifft, da hier die zeitliche Änderung der Eigenform über die Pulsbreite am kleinsten ist und somit die beste Annäherung eines zeitlich stationären optischen Effektes erreicht werden kann.

In einer weiteren bevorzugten Ausgestaltung der optischen Vorrichtung ist für die vorgenannten Zwecke ein Taktgeber für die Pulsfrequenz der Lichtpulse vorgesehen, der wiederum mit zumindest einem Frequenzvervielfacher und zumindest einem Phasenschieberglied verbunden ist, deren Ausgang mit den Vorrichtungen zur Anregung einer Schwingung verbunden ist. Das Taktgebersignal wird dabei zunächst dem Frequenzvervielfacher zugeführt, der ein Signal erzeugt, das ein ganzzahliges Vielfaches (beispielsweise 1-, 2-, 3-, 4-, ...-faches) der Pulsfrequenz darstellt. Das Phasenschieberglied fügt dem Signal eine bestimmte Phasenverschiebung bei, die auch Null sein kann. Das variable Verstärkungsglied steuert die Amplitude der Schwingung, die ebenfalls Null sein kann. Das so erzeugte Signal wird dann den Vorrichtungen zur Anregung einer Schwingung des optischen Elements zugeführt, um das optische Element entsprechend zur Schwingung anzuregen.

In einer weiteren bevorzugten Ausgestaltung der optischen Vorrichtung ist für die genannten Zwecke ein Taktgenerator vorgesehen, der ein Vielfaches der Lichtquellen-Taktfrequenz generiert. Die Taktfrequenz für die Lichtquelle und zur Anregung der optischen Elemente wird aus einem oder mehreren phasensynchronen Frequenzteilern erzeugt und durch einstellbare Phasenschieber und Verstärker nach den Erfordernissen angepasst.

Um die oben beschriebenen mehreren Schwingungseigenmoden des optischen Elements anzuregen, ist vorzugsweise eine Mehrzahl an Frequenzvervielfachern und Phasenschiebergliedern mit dem Taktgeber verbunden, deren Ausgänge mit einem Summierglied verbunden sind, dessen Ausgang mit den Vorrichtungen zur Anregung einer Schwingung verbunden ist. Bei dieser Ausgestaltung werden demnach mehrere frequenzvervielfachte und ggf. phasenverschobene Signale des Taktgebers zu einem Steuersignal aufsummiert, das dann dazu benutzt wird, das optische Element in gewünschter Weise zu einer Schwingung anzuregen, die eine Überlagerung von Schwingungseigenmoden darstellt, mit der der gewünschte optische Effekt erzielbar ist.

In einer weiteren bevorzugten Ausgestaltung weist das optische Element doppelbrechendes Material auf, wodurch ein Polarisationsgrad sowie ein Polarisationszustand der Wellenfront eines Lichtpulses, der durch das in Schwingung versetzte optische Element hindurchtritt, bei einer geeigneten Synchronisierung von Pulsfrequenz und Schwingungsfrequenz gezielt beeinflusst werden kann.

In weiteren bevorzugten Ausgestaltungen kann das optische Element auch mehrschichtig aufgebaut sein, indem beispielsweise das optische Element zwischen zwei Festkörperschichten eine Flüssigkeits- oder Gasschicht aufweist, wobei die Flüssigkeits- oder Gasschicht oder zumindest eine der zwei Festkörperschichten zur Schwingung anregbar ist.

Zur Korrektur von Verzeichnungsverläufen ordnet man das optische Element bevorzugt im Bereich einer Feldebene der optischen Vorrichtung an. Zur Korrektur feldunabhängiger Fehler, sogenannter Öffnungsfehler, wird das optische Element im Bereich einer Pupillenebene der optischen Vorrichtung vorgesehen.

In einer Projektionsbelichtungsanlage der Mikrolithographie kann das optische Element im Projektionsobjektiv zur Bildfehlerkorrektur an all denjenigen Positionen vorgesehen werden, an denen Korrekturelemente vorgesehen sein können. Dies sind bevorzugt Pupillenebenen und Feldebenen, aber auch Positionen zwischen Pupillen- und Feldebene. Auch im Beleuchtungssystem einer Projektionsbelichtungsanlage kann ein in zu Schwingungen anregbares optisches Element zur gezielten Änderung von Intensitätsprofilen eingesetzt werden.

Besonders geeignet als Mittel zur Erzeugung elastischer Schwingungen des optischen Elements sind Vorrichtungen wie Lautsprecher (Tauchspulen, Lorenzmotor), Piezoaktuatoren, elektrostatische, magnetostatische Aktuatoren/Antriebe (Motoren verschiedener Bauarten) oder auch hydraulisch oder pneumatisch gesteuerte Aktuatoren. Selbstverständlich können auch mehrere verschiedenartige Mittel zur Erzeugung elastischer Schwingungen miteinander kombiniert werden.

Vorteilhaft ist es, solche Vorrichtungen zur Schwingungsanregung im Abschattungsbereich des optischen Elements anzuordnen. Mit Abschattungsbereich wird hier und im folgenden derjenige Bereich des optischen Elements bezeichnet, auf den im Betrieb kein Licht der Lichtquelle fällt. Auf diese Weise wird der Durchtritt des Betriebslichts - bei einer Projektionsbelichtungsanlage der Projektionsstrahlung - und entsprechend die Abbildung nicht beeinträchtigt.

Ein solcher Abschattungsbereich kann der Umfang des optischen Elements sein. Soweit das optische Design der optischen Vorrichtung es vorsieht, kann das optische Element auch ein zentrales Mittenloch aufweisen, in dem weitere Vorrichtungen zur Erzeugung von Schwingungen angeordnet sind. Dadurch wird es möglich, eine noch höhere Anzahl von Schwingungsmoden anzuregen. Ein solches Loch zum Angriff von Mitteln zur Erzeugung von Schwingungen kann auch dezentral, das heißt mit einem Versatz gegenüber der optischen Achse, angeordnet sein.

Um zu vermeiden, dass benachbarte optische Elemente ebenfalls zu Schwingungen angeregt werden, ist es vorteilhaft, die Vorrichtungen zur Erzeugung von Schwingungen sowie das oszillierende optische Element selbst gegenüber der Umgebung im wesentlichen zu entkoppeln. Eine solche Schwingungsentkopplung kann vorteilhafterweise über Ausgleichselemente erfolgen, die gegenphasig zur Anregung des optischen Elements oszillieren.

In einer Ausführungsform kann die Entkopplung dadurch erfolgen, dass eine mechanische Verbindung zwischen den in oszillierenden optischen Elementen und weiteren statischen optischen Elementen des Objektivs vermieden wird. Dies ist beispielsweise möglich, indem für die statischen optischen Elemente eine erste Trägerstruktur und eine zweite, von der ersten getrennte bzw. entkoppelte, Trägerstruktur für die oszillierenden optischen Elemente vorgesehen wird.

In einer anderen Ausführungsform zur Entkopplung wird eine unerwünschte Kraftübertragung durch das oszillierende optische Element auf die Umgebung durch Erzeugung von Ausgleichsschwingungen vermieden. Dies kann zum Beispiel durch ein oder mehrere Ausgleichselemente bewirkt werden, die entsprechend gegenphasig schwingen, um so die Schwingung des oszillierenden optischen Elements zu kompensieren.

Das zu elastischen Schwingungen anzuregende optische Element kann eine Planplatte sein. Das optische Element ist dabei vorzugsweise mechanisch steif, also beispielsweise dick, ausgestaltet, da sich hierdurch relativ einfach hochfrequente Moden finden lassen, deren Frequenz auf der Laserfrequenz oder einer der Vielfachen liegt. Das optische Element kann ferner vorzugsweise dünn ausgestaltet sein. Hierbei bieten sich bei dünnen optischen Elementen, beispielsweise dünnen Platten, vorwiegend die relativ hochfrequenten Longitudinalmoden an, um eine Vielzahl auch höherer Schwingungsmoden einzustellen und somit Bildfehler höherer Ordnung zu korrigieren.

Das optische Element ist vorzugsweise als zumindest ein Teilraum der optischen Vorrichtung ausgebildet, der mit Gas oder allgemein einem Fluid befüllt ist. Das Gas des Teilsraums wird mittels der Vorrichtungen zur Erzeugung einer Schwingung in Form von Schallerzeugern (beispielsweise Mikrophonen) in Schwingung versetzt, wodurch lokale Dichtevariationen eine lokale Brechungsindexänderung des Gases bewirken. Trifft ein mit der Schallwelle synchronisierter Lichtimpuls auf den Teilraum, so erfährt die Wellenfront des Lichtpulses eine Veränderung, die zu einer Verbesserung des Abbildungsverhaltens der optischen Vorrichtung führen kann.

In einer weiteren bevorzugten Ausgestaltung der optischen Vorrichtung weist die optische Vorrichtung zumindest zwei voneinander beabstandete optische Elemente auf, zwischen denen ein Zwischenraum mit Gas oder Flüssigkeit angeordnet ist. Bei einer solchen Ausgestaltung der optischen Vorrichtung ist eines der zwei optischen Elemente, die beiden optischen Elemente und/oder der Zwischenraum mit Gas oder Flüssigkeit zur Schwingung anregbar. Im Falle, dass ein erstes optisches Element der zwei optischen Elemente elektrisch isolierend und ein zweites optisches Element der zwei optischen Elemente elektrisch leitend ausgebildet ist, ist es bevorzugt, dass auf das erste optische Element zuerst lokal Ladungen induziert werden, und dann der Zwischenraum mit Gas oder Flüssigkeit zur Schwingung angeregt wird.

In einer anderen Ausführungsform ist das in Schwingung versetzbare optische Element so gestaltet, dass seine Elastizitätseigenschaften nicht über das gesamte optische Element konstant sind, sondern lokal variieren. Unter Elastizitätseigenschaften sind zum Beispiel Steifigkeit oder Dämpfungsverhalten des optischen Elements zu verstehen. Dies kann bei einem transmittierenden optischen Element zum Beispiel dadurch erreicht werden, dass das optische Element eine von der Mitte zum seinem Rand hin lokal variierende Dicke aufweist. Unter der Dicke eines optischen Elements ist der Abstand zwischen seinen beiden optischen Oberflächen zu verstehen, wobei der Abstand parallel zur optischen Achse gemessen wird. Eine derartig lokal variierende Dicke weisen beispielsweise sphärische oder asphärische Linsen oder optische Elemente mit Freiformfläche auf.

Alternativ können lokal variierende Elastizitätseigenschaften auch durch eine geeignete Materialgestaltung des optischen Elements erreicht werden, zum Beispiel, indem das optische Element eine von seiner Mitte zu seinem Rand hin lokal variierende Dichte aufweist.

In einer Weiterentwicklung kann das optische Element von einer Trägervorrichtung gehalten werden, wobei die Trägervorrichtung lokal variierende Elastizitätseigenschaften aufweist. Alternativ kann auch ein Array von optischen Elementen vorgesehen sein, die mittels Verbindungselementen miteinander verbunden sind, wobei diese Verbindungselemente jeweils unterschiedliche Elastizitätseigenschaften aufweisen können.

Das Trägerelement kann so gestaltet werden, dass Eigenmoden der Schwingungen im optisch genutzten Bereich des optischen Elements die gewünschte Form haben.

All diese Ausführungsformen ermöglichen es, genau auf die zu korrigierenden Fehler abgestimmte Schwingungsmoden zu erzeugen. Durch die lokale Variation von Elastizitätseigenschaften wird die Einstellung dieser Schwingungsmoden noch wesentlich flexibler im Vergleich zu einem oszillierenden optischen Element mit homogenen Elastizitätseigenschaften.

Neben Linsenarrays können in anderen Ausführungsformen mit flexiblen Verbindungselementen auch Arrays von Spiegeln oder Gittern oder Kombinationen von Linsen und Spiegeln vorgesehen sein. In einer weiteren Ausführungsform ist es auch möglich, ein solches optisches Element als Array von flachen, insbesondere planparallelen, abschnitts- und/oder zonenweise brechenden Linsensegmenten auszugestalten. Ein solches Array kann als Fresnel-Linse eingesetzt werden.

Bei diesen Arrays von Linsen, Spiegeln, Gittern oder flachen Linsensegmenten können die einzelnen Komponenten des Arrays gleiche oder auch jeweils unterschiedliche Geometrien aufweisen. Durch das Vorsehen unterschiedlicher Geometrien der einzelnen Komponenten wird die Flexibilität des oszillierenden optischen Elements hinsichtlich Bildfehlerkorrektur bzw. Beeinflussung der Wellenfront noch erhöht.

Bei Verwendung eines oszillierenden Linsenarrays mit flexiblen Verbindungselementen werden durch Auswahl einer geeigneten Schwingungsmode gezielt die Fokuslagen der Einzellinsen beeinflusst. Dadurch können beispielsweise Winkel oder Intensitäten der durchtretenden Strahlenbündel beeinflusst werden. Eine spezielle Anwendung eines solchen winkelbeeinflussenden oszillierenden Linsenarrays ist im Beleuchtungssystem einer Projektionsbelichtungsanlage möglich, um gezielt Beleuchtungssettings einzustellen. Unter einem Beleuchtungssetting in einer Projektionsbelichtungsanlage versteht man die Winkelverteilung der Intensitäten der Beleuchtungsstrahlen bei Auftreffen auf das Retikel, welche der Winkelverteilung in einer Feldebene entspricht. Die Einstellung von Beleuchtungssettings mit Hilfe eines solchen oszillierenden Linsenarrays hat den Vorteil, dass durch Wahl unterschiedlicher Schwingungsmoden unterschiedliche Beleuchtungssettings wahlweise eingestellt werden können. Damit ist für einen Wechsel des Beleuchtungssettings kein Wechsel optischer Elemente oder Einschieben von Blenden oder Filtern erforderlich. Stattdessen reicht es aus, einen anderen Schwingungszustand einzustellen.

Ein erfindungsgemäßes oszillierendes Linsenarray kann auch zur Feinkorrektur eines Beleuchtungssettings verwendet werden, welches mit anderen Mitteln eingestellt wird, die aus dem Stand der Technik bekannt sind.

Sämtliche hier beschriebenen zu Schwingungen anregbaren optischen Elemente oder Arrays optischer Elemente können beim Einsatz in einer optischen Vorrichtung, insbesondere in einer Projektionsbelichtungsanlage für die Photolithographie, in einer vorteilhaften Ausführungsform zusammen mit einer Kontrolleinheit eingesetzt werden. Die Kontrolleinheit ist mit einem Messsystem ausgestattet, welches vorgegebene Kontrollparameter des oszillierenden optischen Elements bzw. des Arrays, beispielsweise die Phase oder die Amplitude der Schwingung, lokal ermittelt. Zur Charakterisierung eines einzelnen optischen Elements kann das Messsystem beispielsweise ein Interferometer mit getakteter Beleuchtung oder eine Anordnung von Mikrophonen oder Beschleunigungssensoren umfassen, welche ortsaufgelöst die Druckschwankungen oder Beschleunigung der optischen Flächen registrieren. Zur Charakterisierung eines Arrays von optischen Elementen umfasst das Messsystem in einer bevorzugten Ausführungsform einzelne Sensoren, beispielsweise Fokussensoren, die die Fokuslage der einzelnen Array-Komponenten ermitteln. Die Kontrolleinheit verfügt weiter über ein Auswerte- und Kontrollsystem, welches anhand der von dem Messsystem aufgenommenen Messwerte, gegebenenfalls mittels Vergleich dieser Messwerte mit vorgegebenen Parametern aus Modellrechnungen, die Vorrichtungen zur Anregung von Schwingungen des optischen Elements steuert. Auf diese Weise ist die Genauigkeit der Schwingungsamplitude des oszillierenden optischen Elements oder Arrays und die entsprechende Synchronisation mit der gepulsten Lichtquelle besonders präzise einstellbar.

Eine solche Kontrolleinheit kann für ein einzelnes oszillierendes optisches Element, für mehrere derartige Elemente gleichzeitig oder auch für die gesamte optische Vorrichtung vorgesehen sein. Zusätzlich oder alternativ kann auch ein Wellenfrontsensor vorgesehen sein, der die Wellenfront des gesamten optischen Systems aufnimmt. Die durch den Wellenfrontsensor ermittelten Daten werden ebenfalls durch die Kontrolleinheit verarbeitet und zur Festlegung bzw. Einstellung der zur Korrektur erforderlichen Schwingungsmoden bzw. Schwingungsamplituden des optischen Elements verwendet. Zur Charakterisierung des Gesamtsystems wird vorzugsweise ein Wellenfrontsensor beziehungsweise ein Interferometer verwendet, vorzugsweise ein Interferometer mit mehreren parallel arbeitenden Messkanälen zur synchronen Messung an mehreren Feldpunkten, beispielsweise ein mehrkanaliges Shearing-Interferometer.

In einer Vorrichtung mit einem oder mehreren oszillierenden optischen Elementen besteht ein Vorteil der Charakterisierung und Kontrolle jedes einzelnen dieser Elemente darin, dass individuelle Abweichungen der einzelnen optischen Elemente von Modellrechnungen, welche auf einem idealen optischen Element basieren, berücksichtigt und kompensiert werden können. Eine Charakterisierung und Kontrolle ist aber auch am Gesamtsystem vorteilhaft, da mit Hilfe eines Sensors, der die Charakteristik des gesamten optischen Systems erfasst, das Zusammenwirken der einzelnen oszillierenden Komponenten ermittelt werden kann und die gewünschte Wirkung im Gesamtsystem gezielt eingestellt werden kann.

In einer besonders vorteilhaften Ausgestaltung umfasst das Kontrollsystem weiterhin ein Synchronisationssystem zur Synchronisierung der Schwingungsfrequenz des optischen Elements mit der Pulsfrequenz der Lichtquelle. Die Synchronisation erfolgt anhand der durch das Mess-/ und Auswertesystem bestimmten Parameter für die Schwingungsanregung und anhand der vorgegebenen Pulsfrequenz der Lichtquelle.

Zusätzlich zu einem oder mehreren oszillierenden optischen Elementen können in einem erfindungsgemäßen optischen System auch weitere manipulierbare optische Elemente vorgesehen sein, insbesondere verschiebbare oder verkippbare sowie statisch verformbare optische Elemente. Auch in diesem Fall ist es vorteilhaft, sowohl die Mittel zur Anregung der Schwingung der oszillierenden optischen Elemente als auch die Aktuatorik der weiteren manipulierbaren Elemente mittels einer Kontrolleinheit zu kontrollieren, welche über ein Messsystem verfügt, das sowohl Sensoren zur Bestimmung von Parametern der einzelnen optischen Elemente als auch Sensoren zur Bestimmung von Parametern des Gesamtsystems umfasst.

Um die Korrektur bzw. Verbesserung der Abbildungseigenschaften des Gesamtsystems gezielt zu erreichen, kann die Intensitätsverteilung in der Austrittspupille des Gesamtsystems aus Beleuchtungssystem und Abbildungssystem (Projektionsobjektiv) gemessen werden, anstatt beispielsweise nur separat die Intensitätsverteilung des Beleuchtungssystems zu messen und separat zu korrigieren. Die aufgrund der Messung der Intensitätsverteilung der Austrittspupille sich ergebenden Korrekturwerte dienen dann zur Korrektur der Summenbeiträge aus Beleuchtungssystem und Abbildungssystem, wobei die Korrektur dann im Beleuchtungssystem vorgenommen werden kann.

Wird das optische Element in Reflexion betrieben, kann in einer besonders vorteilhaften Ausführungsform vorgesehen sein, ein flüssiges Medium mit einer reflektierenden Oberfläche als Spiegel zu verwenden.

Sind in einer erfindungsgemäßen optischen Vorrichtung mehrere zu Schwingungen anregbare optische Elemente vorgesehen, ergibt sich durch geeignete Positionierung innerhalb der optischen Vorrichtung und durch geeignete Einstellung und Kombination der jeweils angeregten Schwingungsmoden die Möglichkeit, noch kompliziertere Bildfehler auszugleichen als mit nur einem schwingenden optischen Element.

Näher erläutert wird die Erfindung anhand der Zeichnung.

Fig. 1 zeigt eine schematische Darstellung einer Projektionsbelichtungsanlage mit einem Projektionsobjektiv;

Fig. 2 zeigt schematisch die Schwingung einer dünnen Planplatte mit einer einfachen Schwingungsmode und mit Antriebskraft am Ort der Fixie- rung der Planplatte;

Fig. 3 zeigt schematisch die Schwingung einer dünnen Planplatte mit einer einfachen Schwingungsmode und mit Antriebskraft außerhalb der Fi- xierung;

Fig. 4 zeigt schematisch ein rundes optisches Element mit 8 Aktuatoren;

Fig. 5 zeigt schematisch ein rechteckiges optisches Element mit 12 Aktuato- ren;

Fig. 6 zeigt schematisch ein rundes optisches Element mit zentralem Mitten- loch und Aktuatoren am Umfang des optischen Elements und inner- halb des Mittenlochs;

Fig. 7 zeigt schematisch eine Ausführungsform des optischen Elements als Flüssigkeit in Reflexion;

Fig. 8 zeigt schematisch eine Ausführungsform des optischen Elements als Flüssiglinse in Transmission;

Fig. 9 zeigt schematisch eine Ausführungsform des optischen Elements als Flüssiglinse mit abgeschlossener Umgebung;

Fig. 10 zeigt schematisch eine Ausführungsform des optischen Elements als Gitter;

Fig. 11 zeigt schematisch eine Ausführungsform mit einem Linsenarray;

Fig. 12 zeigt schematisch eine Ausführungsform mit einem Linsenarray auf einem Träger;

Fig. 13 zeigt schematisch eine Ausführungsform mit einem Spiegelarray;

Fig. 14 zeigt schematisch eine Ausführungsform mit einem Array von Spiegeln und Linsen;

Fig. 15 zeigt schematisch eine Ausführungsform mit einem Spiegel- und Linsenarray in Kombination mit Fokussensoren;

Fig. 16 zeigt schematisch eine Mess- und Regelungskonzept für ein einzelnes optisches Element;

Fig. 17 zeigt schematisch eine Objektiv mit einer mechanischen Entkopplung von in Schwingung versetzbaren optischen Elementen und statischen optischen Elementen;

Fig. 18 zeigt ein Prinzipschaltbild einer Steuerung der Anregung einer Schwin- gung des optischen Elements in Synchronisation mit der Pulsfrequenz einer Lichtquelle;

Fig. 19 zeigt schematisch eine weitere Ausführungsform des zur Schwingung anregbaren optischen Elements mit lateraler (longitudinaler) Schwin- gungsanregung;

Fig. 20 zeigt schematisch ein weiteres optisches Element mit transversaler Schwingungsanregung;

Fig. 21 zeigt schematisch eine weitere Ausführungsform des optischen Ele- ments in Form eines Gasresonators zur Anregung von longitudinalen Schwingungsmoden;

Fig. 22    zeigt schematisch eine noch weitere Ausführungsform des optischen Elements als mehrschichtige Planparallelplatte mit lateraler (longitudi- naler) Schwingungsanregung;

Fig. 23    das optische Element in Fig. 22 mit transversaler Schwingungsan-  regung;

Fig. 24    zeigt schematisch eine noch weitere Ausführungsform des optischen Elements als Spiegel;

Fig. 25    zeigt schematisch eine noch weitere Ausführungsform des optischen Elements als gasbefüllter Teilraum der optischen Vorrichtung;

Fig. 26A, 26B    zeigen schematisch eine Anordnung zweier optischer Elemente, zwi- schen denen eine Gasschicht angeordnet ist; und

Fig. 27A, 27B    zeigen schematisch eine noch weitere Ausführungsform des optischen Elements als polarisationsbeeinflussende Planparallelplatte sowie deren Brechungsindexabhängigkeit vom Radius.

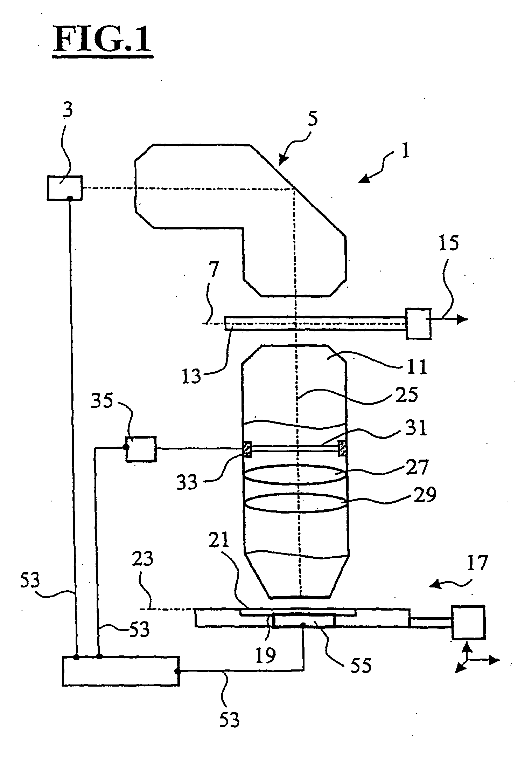

In Fig. 1 ist schematisch eine mikrolithographische Projektionsbelichtungsanlage 1 gezeigt, die zur Herstellung von hochintegrierten Halbleiterbauelementen mittels-Photolithographie vorgesehen ist. Die Projektionsbelichtungsanlage 1 umfasst als Lichtquelle einen gepulsten Excimer-Laser 3 mit einer Arbeitswellenlänge von 193 nm. Alternativ könnten auch Lichtquellen anderer Arbeitswellenlängen, beispielsweise 248 nm oder 157 nm bzw. eine Plasmaquelle der Wellenlänge 13.4 nm verwendet werden, wobei bei einer Wellenlänge von 13.4 nm ausschliesslich Spiegel anstelle von Linsen verwendet werden. Ein nachgeschaltetes Beleuchtungssystem 5 erzeugt in seiner Austrittsebene oder Objektebene 7 ein großes, scharf begrenztes, sehr homogen beleuchtetes und an die Telezentrieerfordernisse des nachgeschalteten Projektionsobjektivs 11 angepasstes Beleuchtungsfeld. Das Beleuchtungssystem 5 hat Einrichtungen zur Steuerung der Pupillenausleuchtung und zum Einstellen eines vorgegebenen Polarisationszustands des Beleuchtungslichts. Insbesondere ist eine Vorrichtung vorgesehen, die das Beleuchtungslicht so polarisiert, dass die Schwingungsebene des elektrischen Feldvektors parallel zu den Strukturen der Maske 13 verläuft.

Im Strahlengang hinter dem Beleuchtungssystem ist eine Einrichtung (Reticle-Stage) zum Halten und Bewegen einer Maske 13 so angeordnet, dass diese in der Objektebene 7 des Projektionsobjektivs 11 liegt und in dieser Ebene zum Scanbetrieb in einer Abfahrrichtung 15 bewegbar ist.

Hinter der auch als Maskenebene bezeichneten Objektebene 7 folgt das Projektionsobjektiv 11, das ein Bild der Maske mit reduziertem Maßstab auf ein mit einem Photolack, auch Resist 21 genannt, belegtes Substrat 19, beispielsweise einen Silizium-Wafer abbildet. Das Substrat 19 ist so angeordnet, dass die ebene Substratoberfläche mit dem Resist 21 im Wesentlichen mit der Bildebene 23 des Projektionsobjektivs 11 zusammenfällt. Das Substrat wird durch eine Einrichtung 17 gehalten, die einen Antrieb umfasst, um das Substrat 19 synchron mit der Maske 13 zu bewegen. Die Einrichtung 17 umfasst auch Manipulatoren, um das Substrat 19 sowohl in z-Richtung parallel zur optischen Achse 25 des Projektionsobjektivs 11, als auch in x- und y-Richtung senkrecht zu dieser Achse zu verfahren. Eine Kippeinrichtung mit mindestens einer senkrecht zur optischen Achse 25 verlaufenden Kippachse ist integriert.

Die zum Halten des Substrats 19 vorgesehene Einrichtung 17 (Wafer-Stage) kann für die Verwendung bei der Immersionslithographie konstruiert sein. Dabei wird eine Flüssigkeit in den Zwischenraum zwischen dem letzten optischen Element des Projektionsobjektivs 11 und dem Substrat 19 eingebracht. Entsprechend sind in einer für die Immersionslithographie angepassten Projektionsbelichtungsanlagen Vorrichtungen zum Zuführen und Ableiten der Immersionsflüssigkeit sowie ein flüssigkeitsdichter Aufnahmebehälter zur Fixierung der Flüssigkeit zwischen Substrat 19 und dem letzten optischen Element vorgesehen.

Das Projektionsobjektiv 11 umfasst optische Elemente 27, 29, die mit Strahlung asymmetrisch beaufschlagt werden. Die nicht rotationssymmetrische Bestrahlung der optischen Elemente führt zur Veränderung der Abbildungseigenschaften der optischen Elemente 27, 29 und entsprechend des gesamten Objektivs im Verlauf der Betriebsdauer. Zur Kompensation solcher alterungsbedingt entstehenden Bildfehler ist im Projektionsobjektiv 11 ein optisches Element 31 vorgesehen, das mittels einer Reihe von Piezo-Aktuatoren 33, die am Umfang des optischen Elements 31 angeordnet sind, in elastische Schwingungen versetzt werden kann. Zur Steuerung der Piezo-Aktuatoren 33 ist eine Kontrolleinheit 35 vorgesehen. Zur Anregung des optischen Elements 31 können neben Piezo-Aktuatoren auch pneumatisch oder hydraulisch gesteuerte Aktuatoren verwendet werden, auch eine akustische Anregung ist möglich.

In der Wafer-Stage 17 ist ein Sensor 55 angeordnet, der die Wellenfront des Gesamtsystems aufnimmt. Dieser Sensor 55 ist vorzugsweise als Wellenfrontsensor bzw. als Interferometer ausgeführt. Dieses Interferometer weist mehrere parallel arbeitende Messkanäle zur synchronen Messung an mehreren Feldpunkten auf. Die Messergebnisse werden über Datenleitungen 53 an einen Steuerrechner 51 übertragen. Dieser Steuerrechner 51 ermittelt aus den Messdaten die während der Betriebsdauer entstehenden Bildfehler und bestimmt anhand dieser Informationen eine Schwingungsmode für das optische Element 31, welche zu einer optimalen Kompensation der Bildfehler führt. Über Datenleitungen 53 ist der Steuerrechner mit der Kontrolleinheit 35 für das optische Element sowie mit der Lichtquelle 3 verbunden. Auf diese Weise regelt der Steuerrechner über die Kontrolleinheit 35 nicht nur die Schwingungsanregung des optischen Elements mit Hilfe der Aktuatoren 33, sondern dient gleichzeitig zur Synchronisation der Schwingung des optischen Elements mit der Pulsfrequenz der Lichtquelle.

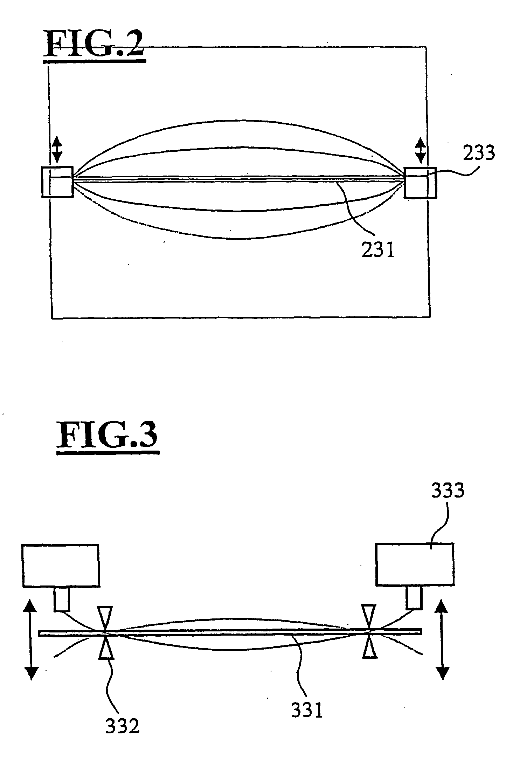

Fig. 2 zeigt schematisch die Wirkungsweise des schwingenden optischen Elements 231. Hier besteht das optische Element 231 aus einer dünnen Planplatte bzw. einer Membran. Diese Membran wird durch Antriebe 233, die an den Befestigungspunkten des optischen Elements 231 angeordnet sind, in Schwingung versetzt. In einem einfachen Fall können die Antriebe beispielsweise so angeordnet sein, dass bei der Schwingung eine zylindrische Verformung des optischen Elements 231 entsteht. Fallen nun einzelne Lichtpulse, beispielsweise einer gepulsten Laserlichtquelle, auf das optische Element 231, und entspricht die Pulsfrequenz des Lasers der Schwingungsfrequenz des optischen Elements 231 oder einem ganzzahligen Vielfachen davon, weist das optische Element 231 bei jedem Auftreffen eines Lichtpulses dieselbe Form auf. In der Wirkung entspricht dies einem statischen optischen Element mit einer entsprechenden zylindrischen Form.

Die Stärke der optischen Wirkung kann im wesentlichen durch zwei Effekte eingestellt werden, nämlich durch die Schwingungsamplitude des optischen Elements 231 und die Phasendifferenz zwischen der Pulsfrequenz und der Schwingungsfrequenz des optischen Elements 231. Treffen die Lichtpulse jeweils gerade zum Zeitpunkt maximaler Auslenkung auf, entspricht die optische Wirkung einem maximal gekrümmten statischen optischen Element. Treffen die Lichtpulse jeweils zu einem anderen Zeitpunkt auf, an dem das schwingende optische Element 231 weniger stark ausgelenkt ist, entspricht die optische Wirkung einem entsprechend weniger stark gekrümmten optischen Element. Die Wirkung eines optischen Elements mit einer Krümmung mit entgegengesetztem Vorzeichen kann erreicht werden, indem die Phasenverschiebung zwischen Pulsfrequenz und Schwingungsfrequenz des optischen Elementes größer als eine halbe Schwingungsperiode gewählt wird.

Die Antriebskraft kann alternativ auch außerhalb der Fixierung des optischen Elements 227 eingebracht werden. Dies ist in Figur 3 schematisch dargestellt.

Durch die Form des optischen Elements 331, durch Anordnung, Anzahl und Position der Auflagepunkte 332 und der Aktuatoren 333, sowie durch die Anregungsfrequenz können verschiedene Eigenmoden und damit unterschiedlichste Deformationen des optischen Elements 331 eingestellt werden.

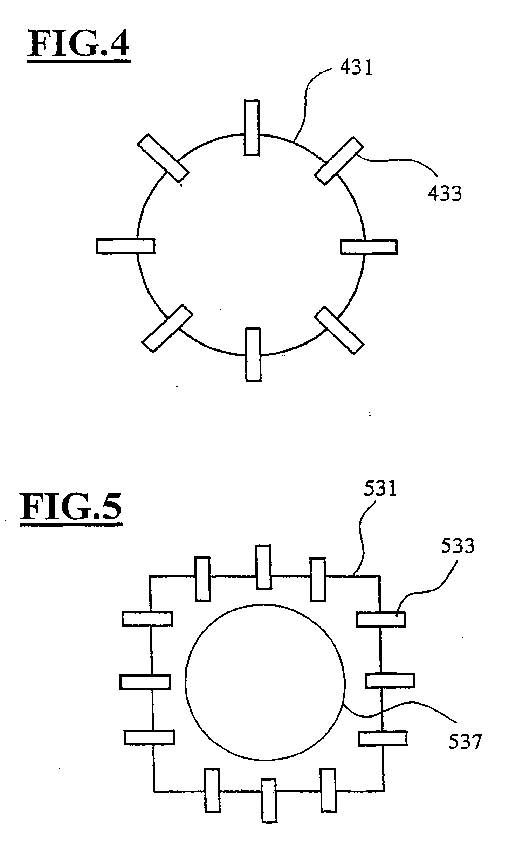

So zeigen die Fig. 4 bis 6 exemplarisch verschiedene Formen des in Schwingung versetzbaren optischen Elements 431. Fig. 4 zeigt ein rundes optisches Element 431 mit acht Aktuatoren 433, die entlang seines Umfangs angeordnet sind. Die Eigenmoden von kreisförmigen Platten oder Membranen, deren Berechnung und Modellierung sind dem Mechanik-Fachmann bekannt. Es wird deshalb an dieser Stelle nicht weiter darauf eingegangen.

Fig. 5 zeigt eine andere Ausführungsform des optischen Elements 531 als rechteckige Planplatte mit 12 Aktuatoren 533, die entlang ihres Umfangs angeordnet sind. Der optische Nutzbereich 537 liegt im Zentrum der rechteckigen Planplatte. Die Aktuatoren 533 sind so angeordnet, dass der Nutzbereich nicht eingeschränkt wird. Die Eigenmoden von rechteckigen Platten oder Membranen, deren Berechnung und Modellierung sind dem Mechanik-Fachmann ebenfalls bekannt.

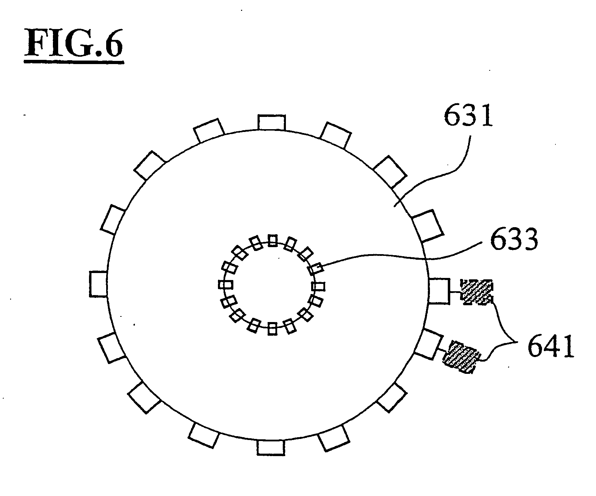

Fig. 6 zeigt eine weitere Ausführungsform des optischen Elements 631 mit einem zentralen Mittenloch 639. Hier sind sowohl am Umfang des optischen Elements 631 als auch am Mittenloch 639 Aktuatoren 633 angeordnet. Die Anzahl und Anordnung der Aktuatoren 633 bestimmt die Anzahl der Moden, die angeregt werden können.

Die Aktuatoren 633 sind mit Ausgleichselementen 641 verbunden, die gegenphasig zur Anregung des optischen Elements 631 oszillieren. Dies dient der Entkopplung der Aktuatoren 633 von der Fassung des optischen Elements 631 bzw. von der gesamten Fassungsstruktur der optischen Vorrichtung. Auf diese Weise wird vermieden, dass die zur Schwingungsanregung des optischen Elements 631 aufgebrachten Kräfte in die Fassung eingetragen werden und benachbarte optische Elemente in Schwingungen versetzen. Die Ausgleichselemente 641 sind so ausgelegt, dass die auftretenden Kräfte genau kompensiert werden. Derartige Ausgleichselemente können selbstverständlich auch bei allen anderen hier angegebenen Ausführungsformen der Erfindung vorgesehen sein.

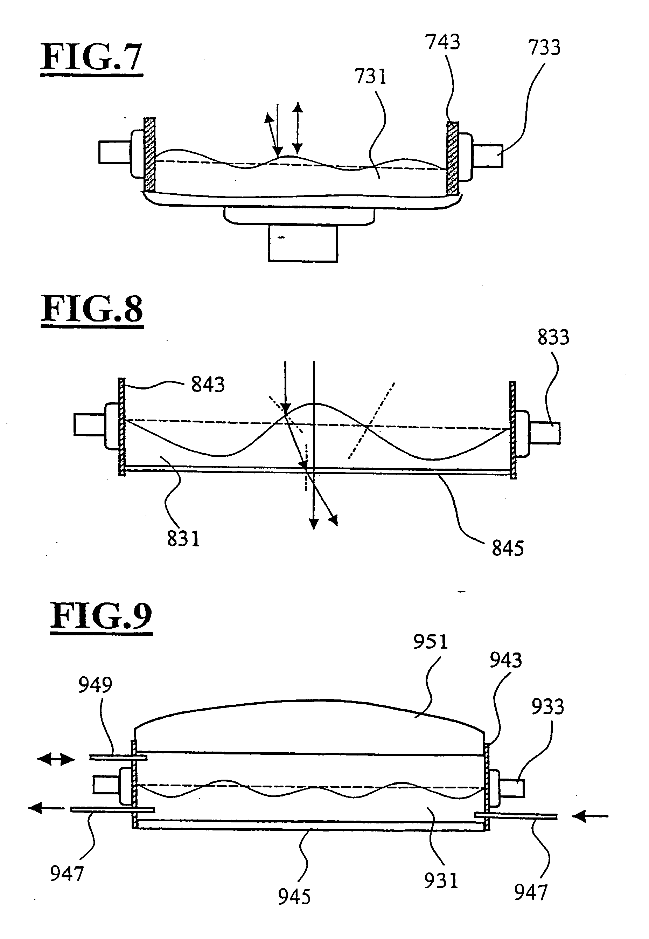

In einer weiteren Ausführungsform der Erfindung gemäß den Fig. 7 und 8 kann ein flüssiges Medium als optisches Element 731, 831 vorgesehen sein. Das schwingende optische Element 731 wird hier in Reflexion betrieben. Die Flüssigkeit kann dabei selbst reflektierend sein, wie beispielsweise Quecksilber. Gegebenenfalls kann die Flüssigkeit aber auch mit einer reflektierenden dünnen elastischen Schicht belegt sein, beispielsweise mit einer Goldfolie. Verformungen der Flüssigkeitsoberfläche übertragen sich dann auf diese Folie. Die Flüssigkeit wird von einem flüssigkeitsdichten Behälter 743 gehalten. Die Schwingungsanregung erfolgt mittels akustischer Anregungen durch Lautsprecher 733, die am Umfang des Flüssigkeitsbehälters 743 angebracht sind.

Auch der Betrieb in Transmission ist bei einem optischen Element 831 aus einem flüssigen Medium möglich. Ein flüssiges in Transmission betriebenes optisches Element bezeichnet man auch als Flüssiglinse. In Fig. 8 ist eine solche Flüssiglinse dargestellt. Die Flüssigkeit befindet sich in einem Flüssigkeitsbehälter 843, dessen Basis aus einer transparenten Planplatte 845, beispielsweise aus Quarzglas, besteht und an dessen Umfang Lautsprecher zur akustischen Anregung der Flüssigkeit angebracht sind. Als Flüssigkeit kommen beispielsweise destilliertes Wasser, Schwefelsäure, perfluorierte Ether oder Zyklohexan in Frage. Die Form des Flüssigkeitsbehälters 843 kann so gestaltet sein, dass die Basis des Behälters als weiteres optisches Element gestaltet ist, beispielsweise als plankonkave oder plankonvexe Linse.

Wird eine Flüssigkeit als optisches Element verwendet, ist eine geschlossene Ausführungsform, wie sie in Fig. 9 dargestellt ist, besonders vorteilhaft. Auf diese Weise kann die optische Vorrichtung frei von Verunreinigungen durch verdunstende Flüssigkeitsmoleküle gehalten werden. Andererseits können auch keine Kontaminationspartikel aus der Umgebung in die Flüssigkeit gelangen. Die Flüssiglinse 931 in Fig. 9 ist von einem Flüssigkeitsbehälter 943 umgeben, dessen Basis aus einer transparenten Planplatte 945, beispielsweise aus Quarzglas, besteht. Nach oben ist der Flüssigkeitsbehälter durch eine Plankonvexlinse 951 abgeschlossen. Zur Erneuerung der Flüssigkeit ist ein Flüssigkeitszulauf und -ablauf 947 vorgesehen. Durch Änderung der Flüssigkeitsmenge ist die Dicke der Flüssigkeitslinse einstellbar. Eine Lüftungsöffnung 949 sorgt für den Druckausgleich. Am Umfang des Flüssigkeitsbehälters 947 sind Lautsprecher 933 zur Schwingungsanregung der Flüssiglinse vorgesehen.

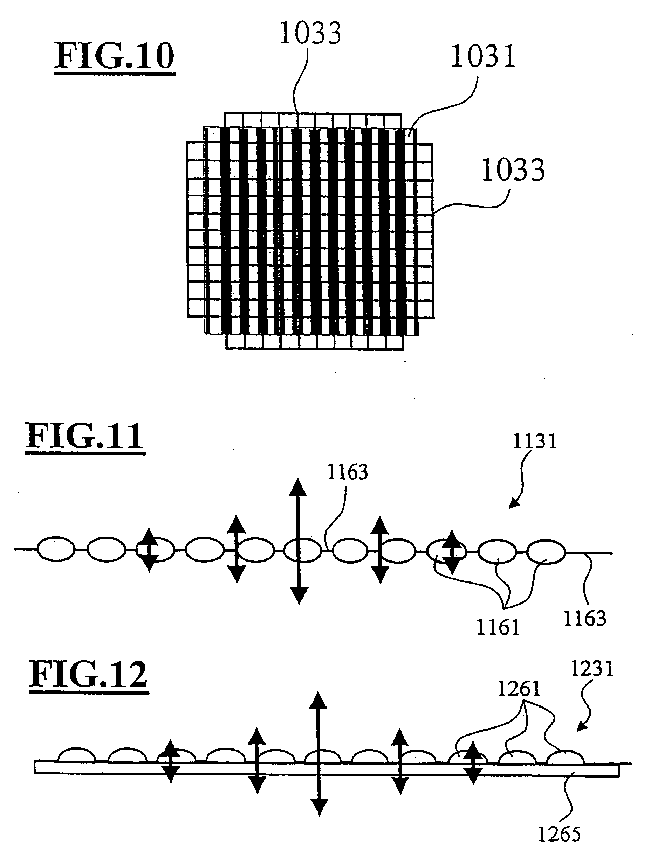

In einer weiteren Ausführungsform können bei entsprechend hohen Schwingungsmodi auch gitterartige periodische Strukturen erzeugt werden. Auf diese Weise lassen sich beispielsweise Phasengitter als lineare Sinusgitter, Kreuzgitter oder auch Radialgitter erzeugen. Fig. 10 zeigt ein rechteckiges optisches Element 1031 mit einer reflektiven Oberfläche, an dessen Umfang eine Vielzahl von Aktuatoren 1033 angebracht sind, wobei in dem optischen Element 1031 durch Schwingungsanregung eine gitterartige Struktur erzeugt wurde.

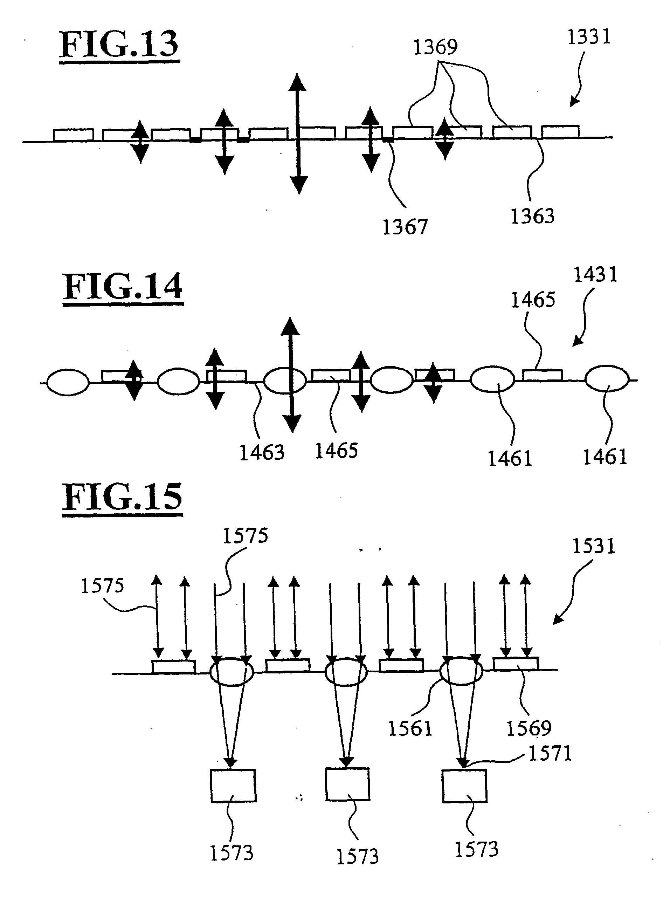

Eine andere Ausführungsform des schwingenden optischen Elements ist in verschiedenen Ausgestaltungen in den Figuren 11 bis 14 dargestellt. Das optische Element ist hier als Array einzelner optischer Komponeteten gestaltet, zum Beispiel in Form eines Linsen- (Fig. 11 und 12) oder Spiegelarrays (Fig. 13) oder auch als Array aus Linsen und Spiegeln (Fig. 14).

Fig. 11 zeigt ein in Schwingung versetzbares Linsenarray 1131, bei dem die Einzellinsen 1161 miteinander durch flexible Verbindungselemente 1163 verbunden sind. In einer einfachen Form sind die Einzellinsen 1163 als ebenes Linsenarray 1131 angeordnet. In einer alternativen Ausführungsform muss das Array nicht eben sein, sondern kann in einer unebenen, in z-Richtung vorgeformten Matrix angeordnet sein. Die Amplitude einer möglichen Schwingung des Linsenarrays 1131 sind mit Pfeilen dargestellt.

Fig. 12 zeigt ein Linsenarray 1231 mit Einzellinsen 1261 auf einem gemeinsamen Träger 1265. Dieser Träger kann aus einem Material bestehen, welches lokal eine unterschiedliche Dichte aufweist, beispielsweise kann die Dichte von der Mitte des Trägers zum Rand hin kontinuierlich abnehmen. Auf diese Weise wird die Schwingungsamplitude lokal beeinflusst, so dass die effektive optisch wirksame Form des synchronisiert mit der Pulsfrequenz der Lichtquelle schwingenden optischen Elements, statt grundsätzlich im Querschnitt eine Sinusform anzunehmen, durch die lokal unterschiedliche Dichte frei gestaltbar ist.

Fig. 13 zeigt ein Spiegelarray 1331 mit flexiblen Verbindungselementen 1363 und 1367 zwischen den Einzelspiegeln 1369. Die Verbindungselemente 1363 und 1367 weisen jeweils eine unterschiedliche Steifigkeit auf. Durch die Wahl unterschiedlich steifer Verbindungselemente lässt sich die effektive optisch wirksame Form des synchronisiert mit der Pulsfrequenz der Lichtquelle schwingenden optischen Elements lokal ebenfalls beeinflussen.

Fig. 14 zeigt ein Array 1431 aus Einzellinsen 1461 und Einzelspiegeln 1469, welche durch Verbindungselemente 1463 miteinander verbunden sind.

Bei den hier beschriebenen Arrays kann die lokale Phase und Amplitude der einzelnen Elemente mittels Fokus-Sensoren kontrolliert werden. Dies ist in Fig. 15 dargestellt. Die Betriebsstrahlung 1575 wird an den Einzelspiegeln 1569 reflektiert, während die Einzellinsen 1561 die Betriebsstrahlung 1575 im Punkt 1571 fokussieren. Die Fokussensoren 1573 können für einen Regelkreis für die Aktuatoren 33 verwendet werden, welche das optische Element 31 zur Schwingung anregen. Ein solcher Regelkreis kann nicht nur für Arrays von Einzelkomponenten eingesetzt werden, sondern auch für ein einzelnes schwingendes optisches Element gemäß den Figuren 1 bis 10.

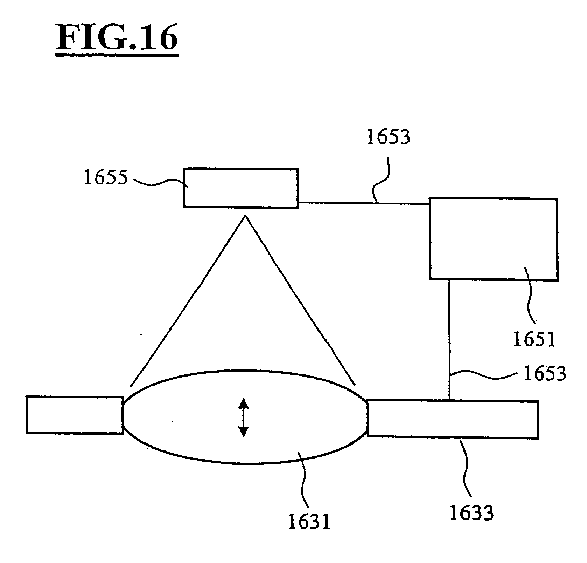

Der schematische Aufbau eines derartigen Regelkreises für die Regelung einer Schwingungsanregung eines einzelnen optischen Elements 1631 ist in der Fig. 16 dargestellt. Ein Messsystem 1655 dient zur Charakterisierung der erzeugten Deformation des optischen Elements. Das Messsystem 1655 kann beispielsweise ein Interferometer mit getakteter Beleuchtung zur Messung der Oberfläche umfassen oder auch eine Anordnung von Mikrophonen besitzen, die ortsaufgelöst die Druckschwankungen der optischen Flächen registrieren. Es ist ebenfalls möglich, dass das Messsystem 1655 eine Anordnung von Beschleunigungssensoren aufweist, die ortsaufgelöst die Beschleunigungsschwankungen der optischen Flächen registrieren. Über Datenleitungen 1653 können die Messwerte an ein Auswerte- und Kontrollsystem 1651 weitergegeben werden, das die Messwerte erfasst und verarbeitet, insbesondere auch speichert. Die Messwerte können mit Idealwerten, zum Beispiel mit einer idealen Amplitude, die für die Schwingung eines idealen optischen Elements aus Modellrechnungen gewonnen wurden, verglichen werden. Die Abweichungen vom Idealzustand werden ermittelt und die Bewegung der Aktuatoren 1633 zur Schwingungsanregung gegebenenfalls so angepasst, dass die Schwingungscharakteristik des optischen Elements 1631 dem Idealzustand nahe kommt. Die Anpassung der Aktuatorenbewegung erfolgt ebenfalls durch das Auswerte- und Kontrollsystem 1651 über eine Datenleitung 1653, die mit der Aktuatorik 1633 verbunden ist.

Das Auswerte- und Kontrollsystem 1651 dient außerdem dazu, die Schwingungsfrequenz des optischen Elements 1631 mit der Pulsfrequenz der Lichtquelle (nicht in Fig. 16 dargestellt) zu synchronisieren. Dazu ist das Auswerte- und Kontrollsystem 1651 mit der Lichtquelle verbunden.

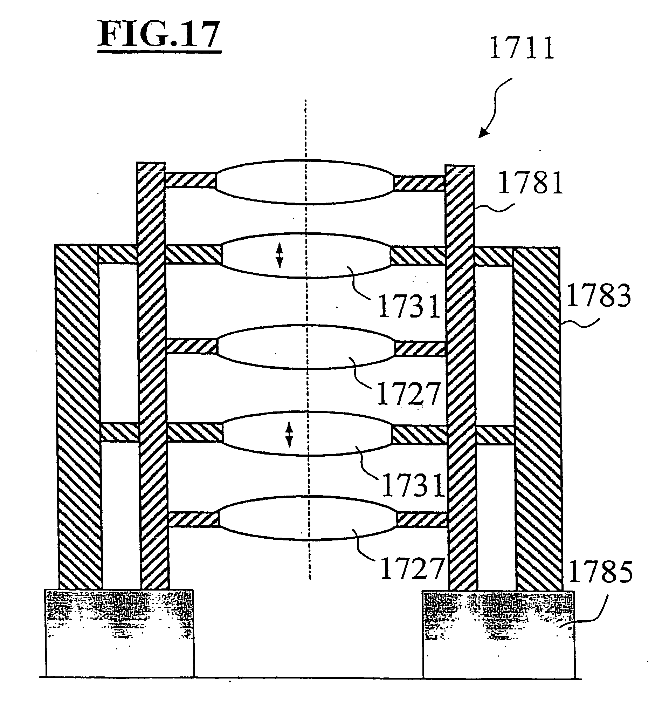

Um zu verhindern, dass durch die Oszillation des optischen Elements 31 in unerwünschter Weise über die Linsenfassung und Aktuatorik Kräfte auf die Umgebung, insbesondere auf die Objektivstruktur übertragen werden, ist eine mechanische Entkopplung des oszillierenden optischen Elements von der Umgebung vorgesehen. In Fig. 17 ist eine Ausführungsform eines Objektivs mit einer derartigen Entkopplung dargestellt. Dabei sind die oszillierenden optischen Elemente 1731 in einer ersten Trägerstruktur 1783 angeordnet, während die statischen optischen Elemente 1727 in einer zweiten Trägerstruktur 1781 angeordnet sind. Beide Trägerstrukturen 1781 und 1783 sind mechanisch voneinander getrennt. Die innere Trägerstruktur 1781 hat ausgesparte Ringsegmente, ähnlich einer Krone. Die äußere Trägerstruktur 1783 greift mit Querarmen 1787 durch die Aussparungen der inneren Trägerstruktur 1781. Es ist auch möglich, mehr als zwei getrennte Trägerstrukturen vorzusehen. Beispielsweise kann für jedes oszillierende optische Element eine eigene Trägerstruktur vorgesehen sein.

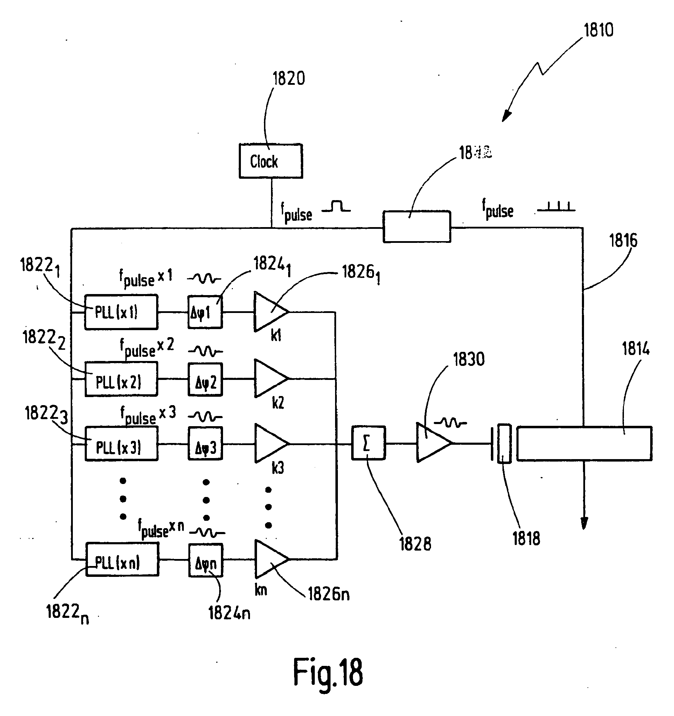

Fig. 18 zeigt ein Prinzipschaltbild einer optischen Vorrichtung 1810, die beispielsweise die Projektionsbelichtungslage 1 in Fig. 1 sein kann.

Die optische Vorrichtung 1810 weist eine Lichtquelle 1812, beispielsweise einen Laser, auf. Die optische Vorrichtung 1810 weist ferner ein optisches Element 1814 auf, das beispielsweise das optische Element 31 im Projektionsobjektiv 11 der Projektionsbelichtungsanlage 1 in Fig. 1 sein kann. Es versteht sich jedoch, dass das optische Element 1814 auch ein optisches Element des Beleuchtungssystems 5 in Fig. 1 sein kann.

Das von der Lichtquelle 1812 emittierte Licht ist in Fig. 18 mit einem Pfeil 1816 dargestellt und wird durch das optische Element 1814 hindurch gerichtet.

Das optische Element 1814 ist, wie in den vorherigen Ausführungsbeispielen beschrieben, zur Schwingung anregbar, wobei zu diesem Zweck dem optischen Element 1814 Vorrichtungen 1818 zur Anregung einer Schwingung, beispielsweise in Form eines Piezoaktuators, zugeordnet sind.

Der Lichtquelle 1812 ist ein Taktgeber 1820 (clock) zugeordnet, der der Lichtquelle 1812 ein Taktsignal mit der Pulsfrequenz $f_{pulse}$ zuführt, so dass die Lichtquelle 1812 gepulstes Licht mit der Pulsfrequenz $f_{pulse}$

abgibt.

Mit dem Taktgeber 1820 sind des Weiteren eine Mehrzahl (n) an Frequenzvervielfachern (phase locked loop (pll)) $1822_i$ (i = 1, ..., n) verbunden. Jeder der Frequenzvervielfacher $1822_i$ erzeugt ein ganzzahliges Vielfaches der Pulsfrequenz $f_{pulse}$. Beispielsweise erzeugt der Frequenzvervielfacher $1822_3$ ein Signal mit einer Frequenz, die das 3-fache der Pulsfrequenz $f_{pulse}$ ist.

Jedem Frequenzvervielfacher $1822_i$ ist ein Phasenschieberglied $1824_i$ zugeordnet, das die jeweilige Phase des frequenzvervielfachten Signals um einen einstellbaren Wert verschiebt oder unverändert lässt (Phasenverschiebung Null).

Den Phasenschiebergliedern $1824_i$ ist jeweils ein Amplitudenverstärkerglied $1826_i$ nachgeordnet, das die Signalamplitude in geeigneter Weise einstellt, und zwar mit einem Faktor kleiner oder größer gleich 1.

Alle so bearbeiteten Signale werden einem Summierglied 1828 zugeführt und von diesem aufsummiert. Der Ausgang des Summierglieds 1828 ist dann mit einem Signalverstärker 1838 verbunden, dessen Ausgang mit den Vorrichtungen 1818 zur Anregung einer Schwingung des optischen Elements 1814 verbunden ist. Die mit dem verstärkten Summensignal beaufschlagten Vorrichtungen 1818 zur Anregung einer Schwingung regen schließlich das optische Element 1814 entsprechend dem Summensignal an.

Da die Lichtpulse der Lichtquelle 1812 phasensynchron zu den Modulationsfrequenzen des optischen Elements 1814 sind, tasten diese immer den gleichen Zustand des periodisch angeregten optischen Elements 1814 ab. Die periodisch modulierten Abbildungseigenschaften sehen somit für die Lichtpulse zeitlich quasi stationär aus, ähnlich einem Stroboskop.

Je nach Erfordernis kann man longitudinale und/oder transversale Schwingungsmoden einer Planplatte, einer Linse oder eines Spiegels dazu nutzen, um bei geeigneter Synchronisation mit den Lichtpulsen eine ortsabhängige stationär erscheinende optische Wirkung zu erzielen.

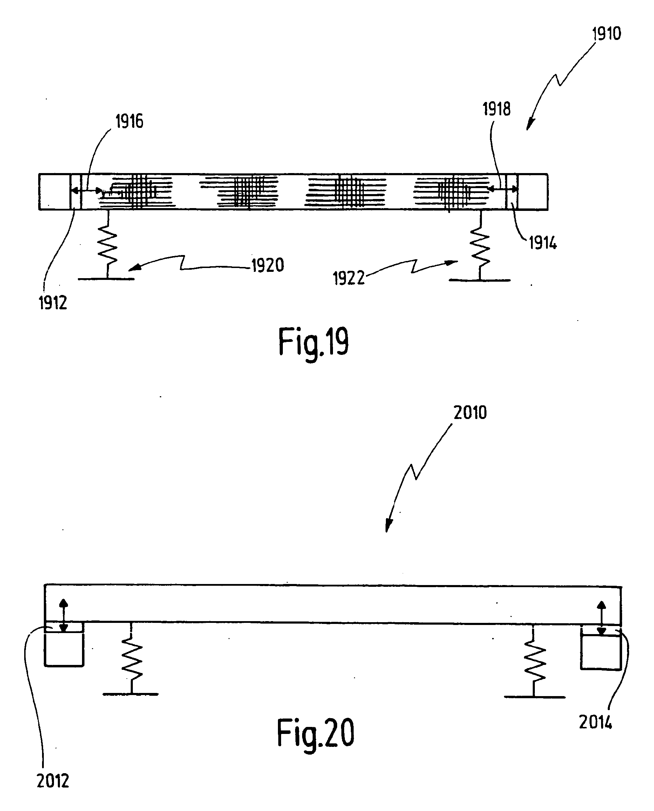

In Fig. 19 ist ein optisches Element 1910 dargestellt, das als transparente Planplatte ausgebildet ist. Das optische Element 1910 kann auch als Linse, Spiegel und dergleichen ausgebildet sein.

Am Rand des optischen Elements 1910 sind Vorrichtungen 1912, 1914 zur Anregung von Schwingungen des optischen Elements 1910 angeordnet. Die Vorrichtungen 1912, 1914 sind beispielsweise Piezoelemente. Mit den Vorrichtungen 1912, 1914 können vorwiegend laterale, d.h. longitudinale, Eigenmoden des optischen Elements 1910 resonant angeregt werden. Über die ortsabhängige Modulation der Dehnung (dargestellt durch dunkle und helle Abschnitte des optischen Elements 1910) wird auch der Brechungsindex bzw. die Doppelbrechung ortsabhängig mit einer durch die Anregung einstellbaren Schwingungsamplitude moduliert. Die Anregungsrichtung ist mit Pfeilen 1916, 1918 veranschaulicht. Die Modulation des Brechungsindexs dient dann der Erzielung der gewünschten optischen Wirkung.

An dem optischen Element 1910 sind des Weiteren Schwingungsentkopplungsmittel 1920, 1922 angeordnet, um das optische Element 1910 von anderen optischen Elementen des optischen Systems, in dem das optische Element 1910 vorhanden ist, schwingungszuentkoppeln.

Fig. 20 zeigt ein mit dem optischen Element 1910 vergleichbares optisches Element 2010, bei dem Vorrichtungen 2012, 2014 zur Anregung von Schwingungen quer an dem optischen Element 2010 angreifen, um transversale Schwingungsmoden des optischen Elements 2010 anzuregen.

Während die longitudinalen Schwingungsmoden des optischen Elements 1910 in Fig. 19 nicht oder im Wesentlichen nicht zu einer Formänderung der Oberflächen des optischen Elements 1910 führen, führen die transversalen Schwingungen des optischen Elements 10 zu einer Formvariation, die zu einer optischen Wirkung führt. Bei dem optischen Element 1910 beruht die modulierte optische Wirkung dagegen überwiegend auf einer modulierten Verteilung des Brechungsindexes im optischen Element 1910.

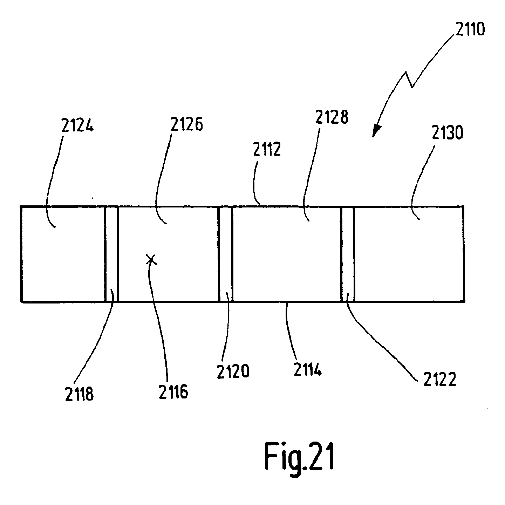

Fig. 21 zeigt ein optisches Element 2110, das zwischen zwei Platten 2112 und 2114 einen gasgefüllten oder flüssigkeitgefüllten Raum 2116 aufweist.

Mittels geeigneter Vorrichtungen zur Anregung einer Schwingung werden in dem Gas longitudinale Schwingungsmoden angeregt, die sich in einer modulierten Dichteverteilung und damit einem ortsabhängig modulierten Brechungsindex äußern.

In Fig. 21 sind Bereiche höherer Dichte 2118, 2120, 2122 und Bereiche geringerer Dichte 2124, 2126, 2128 und 2130 dargestellt.

Die Bereiche höherer Dichte bzw. geringerer Dichte 2118-2122 bzw. 2124-2130 sind gleichzeitig Bereiche höheren Drucks bzw. niedrigeren Drucks. Bei einem Druckunterschied von beispielsweise 28 Pa zwischen den Bereichen höheren Drucks und den Bereichen niedrigeren Drucks ergibt sich ein Brechungsindexunterschied $\Delta n$ von etwa $8.3 \times 10^{-6}$.

Der gasgefüllte Raum 2116 des optischen Elements 2110 kann hinsichtlich der Modulationsfrequenzen angepasst werden, wobei auch die Bereiche höherer Dichte bzw. niedrigerer Dichte 2118-2122 bzw. 2124-2130 durch eine geeignete Wahl der Schwingungsanregung örtlich verschoben werden können.

Longitudinale Schwingungsmoden können in verschiedenen Richtungen angeregt werden, beispielsweise wie in Fig. 21 gezeigt in Lichtdurchtrittsrichtung, quer dazu oder gleichzeitig in den beiden zuvor genannten Richtungen.

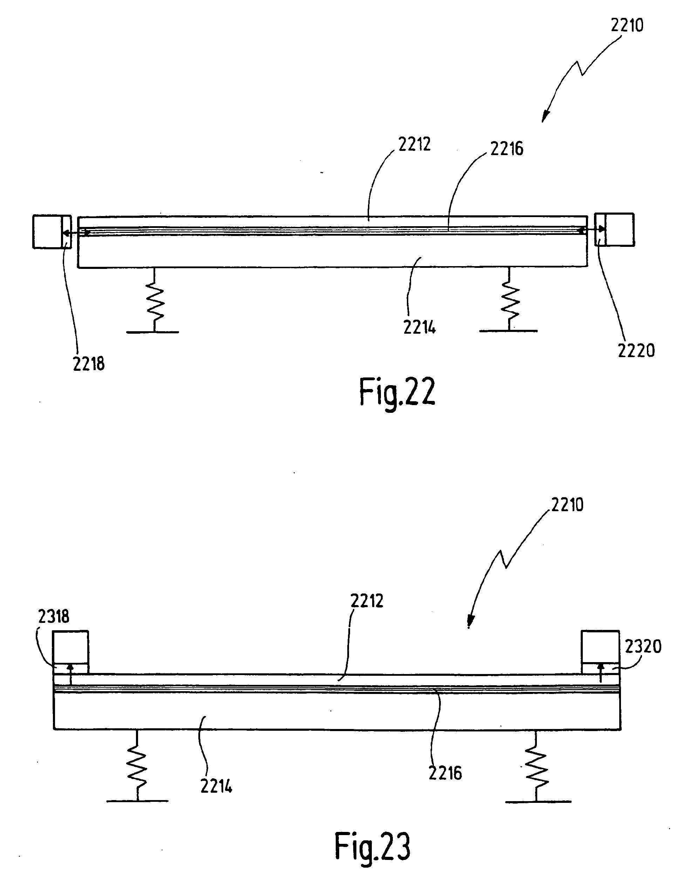

Fig. 22 zeigt ein weiteres optisches Element 2210, das zwischen zwei Festkörperschichten 2212 und 2214 eine Flüssigkeitsschicht, beispielsweise eine Wasserschicht 2216, aufweist. Die Festkörperschichten 2212, 2214 sind beispielsweise als transparente Planplatten ausgestaltet.

Durch seitlich angeordnete Vorrichtungen 2218, 2220 kann die Flüssigkeitsschicht 2216 zur Schwingung angeregt werden, um entweder über den dichteabhängigen Brechungsindex der Flüssigkeit und/oder über die Dickenvariation der Flüssigkeitsschicht 2216 aufgrund von Druckvariationen in der Flüssigkeit und der Nachgiebigkeit der Festkörperschichten 2212, 2214 eine optische Wirkung zu erzielen.

Fig. 23 zeigt das optische Element 2210 in Fig. 22, wobei im Unterschied zu Fig. 22 Vorrichtungen 2318, 2320 zur Anregung einer Schwingung des optischen Elements 2210 transversal an dem optischen Element 2310 angreifen. Angeregt wird hierbei nur die Festkörperschicht 2212, während die Festkörperschicht 2214 aufgrund ihrer größeren Dicke ausreichend starr ist, so dass sich die transversalen Schwingungsmoden der Festkörperschicht 2312 nicht über die Flüssigkeitsschicht 2216 auf die Festkörperschicht 2214 übertragen.

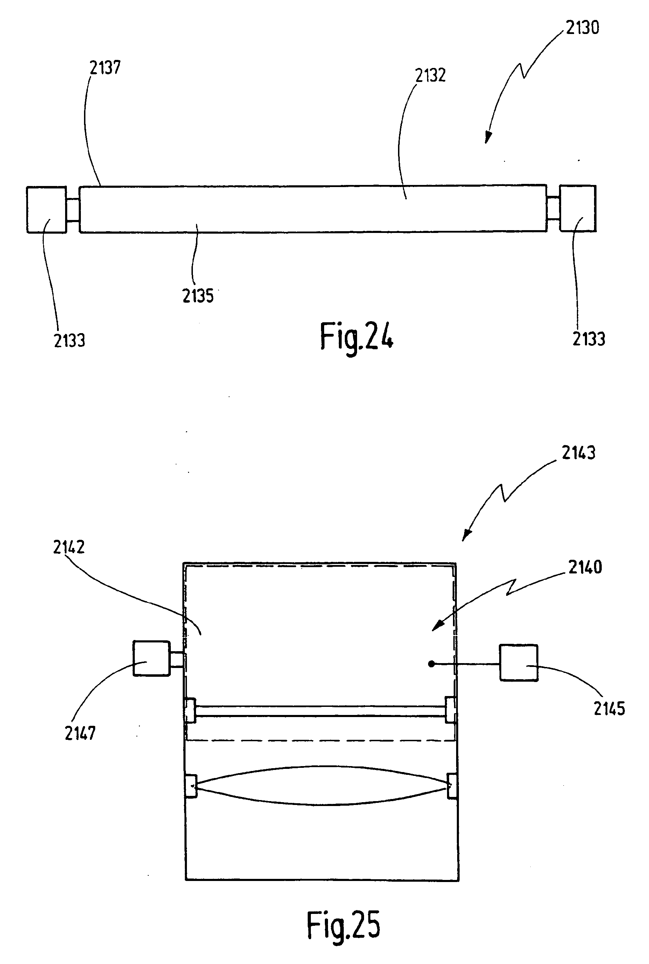

Fig. 24 zeigt eine weitere Ausführungsform eines optischen Elements 2130, das als Spiegel 2132 ausgebildet ist. An dem Spiegel 2132 sind Vorrichtungen 2133 zur Erzeugung einer Schwingung des optischen Elements 2130 angeordnet, die längs an einem Spiegelsubstrat 2135 angreifen. Hierdurch wird das Spiegelsubstrat 2135 in Schwingung versetzt, so dass eine reflektierende Spiegeloberfläche 2137 zeitlich oszilliert, wodurch eine gewünschte optische Korrekturwirkung der Wellenfront eines auf den Spiegel 2132 treffenden Lichtpulses erreicht wird. Unter einer zeitlichen Variation der reflektierenden Spiegeloberfläche 2137 ist beispielsweise eine örtliche Dichtevariation der Spiegeloberfläche 2137 oder eine räumliche Auslenkung lokaler Punkte der Spiegeloberfläche 2137 zu verstehen.

In Fig. 25 ist eine weitere Ausführungsform eines optischen Elements 2140 gezeigt, das als Teilraum 2142 einer optischen Vorrichtung 2143 ausgebildet ist (vgl. gestrichelte Linien in Fig. 25). Der Teilraum 2142 ist mit einem Gasreservoir 2145 verbunden und mit einem Gas, beispielsweise getrockneter Luft (n = 1,000292), Kohlendioxid (n = 1,00045) oder Xenon (n = 1,00706) gefüllt. Ferner sind Vorrichtungen 2147 zu Erzeugung einer akustischen Schwingung des Gases des Teilraums 2142 vorhanden, die in dem gezeigten Ausführungsbeispiel als Schallerzeuger oder Mikrophone ausgestaltet sind. Mittels der Vorrichtungen 2147 wird in dem Gas des Teilraums 2142 eine zeitlich modulierte Schallwelle erzeugt, wodurch eine lokale Dichteänderung in dem geschlossenen Teilraum 2142 induziert wird. Die Schallwelle wird an den Seiten des Teilraums 2142 reflektiert. Die Schwingungsfrequenz ist mit der Pulsfrequenz der Lichtpulse synchronisiert, so dass zu einem definierten Zeitpunkt, bei dem das Gas ein bestimmtes Dichtemuster aufweist, der Lichtpuls durch den Teilraum 2142 hindurchtritt. Dies ermöglicht eine gezielte Beeinflussung des Wellenfrontverlaufs des Lichtpulses. An dem Teilraum 2142 können ferner Dämpfungselemente angeordnet sein, die die erzeugte Schallwelle geeignet dämpfen, so dass die Wellenfront zweiter aufeinander folgender Lichtpulse jeweils verschieden verändert werden kann.

Die Ausgestaltung des optischen Elements 2140 als gasbefüllter Teilraum 2142 der optischen Vorrichtung 2143 ermöglicht vorteilhafterweise eine besonders einfache, kostengünstige und im Betrieb des optischer optischen Vorrichtung 2143 durchführbaren Verbesserung des Abbildungsverhaltens der optischen Vorrichtung 2143.

Das optische Element 2140 kann auch als der gesamte Innenraum der optischen Vorrichtung 2143 oder als scheibenförmiges Volumen beispielsweise im Bereich des Lichtdurchtritts der optischen Vorrichtung 2143 ausgebildet sein.

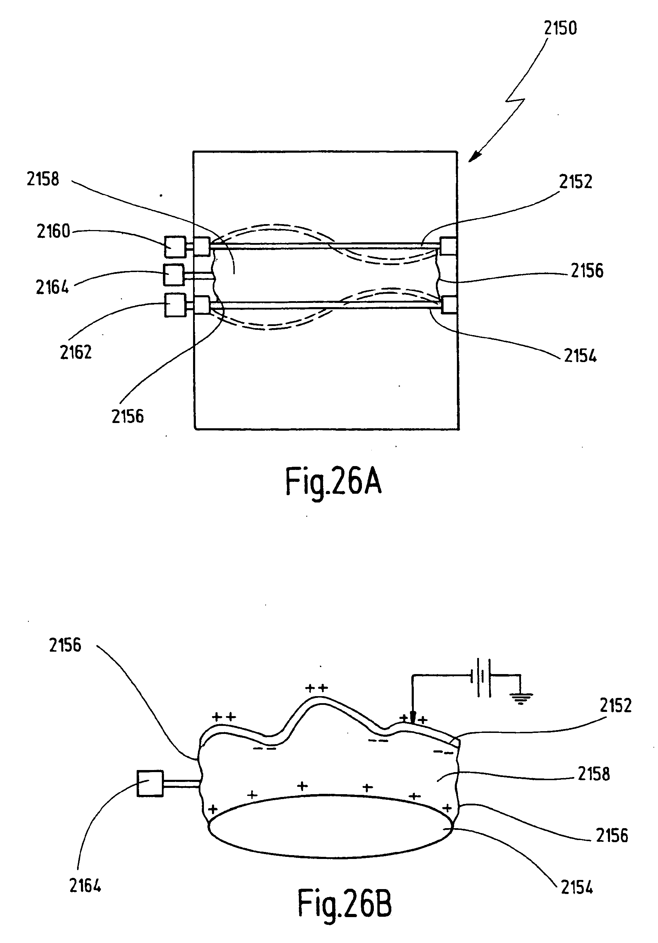

Fig. 26A zeigt eine optische Vorrichtung 2150, in der zwei in Schwingung versetzbare optische Elemente 2152, 2154 aufgenommen sind. Die zwei optischen Elemente 2152, 2154 können beispielsweise zwei voneinander beabstandete kreisförmige Planparallelplatten oder auch ein Pellikel und eine Maske oder eine Linse sein. Die zwei optischen Elemente 2152, 2154 sind über elastische Seitenwände 2156 miteinander verbunden, wobei ein Zwischenraum 2158 mit einem Gas, beispielsweise Argon, gefüllt ist. Das erste optische Element 2152, das in Lichtausbreitungsrichtung der Lichtpulse stromaufwärts angeordnet ist, wird mittels Vorrichtungen 2160 zu einer transversalen Schwingung angeregt. Diese führt zu einer ortsabhängigen Auslenkung des Pellikels oder optischen Elements, die in Fig. 26A schematisch übertrieben durch die gestrichelten Linien dargestellt ist. Zusätzlich wird dem Gas eine bestimmte Topologie aufgeprägt, was zusätzlich zu einer Dichte- und somit zu einer Brechungsindexvariation des Gases führt. Dies führt zu einer gezielten Beeinflussung der Wellenfront der Lichtpulse.

Es ist ebenfalls möglich, dass die beiden optischen Elemente 2152, 2154 zu einer transversalen Schwingung angeregt werden können. Dazu ist an dem optischen Element 2154 ebenfalls eine Vorrichtung 2162 zur Erzeugung einer Schwingung angeordnet. Die Schwingungsfrequenzen der beiden optischen Elemente 2152, 2154 können beispielsweise um 180° zueinander phasenversetzt sein. Aufgrund der in den beiden optischen Elementen 2152, 2154 induzierten Schwingungen erfährt das Gas in dem Zwischenraum 2158 eine Dichte- und Brechungsindexvariation, die die Wellenfront eines zeitlich geeignet getakteten Lichtpulses verändert und deren Fehlverlauf gezielt minimiert.

Es ist ebenfalls möglich, dass das Gas in dem Zwischenraum 2158 direkt mittels eines Schallerzeugers 2164 zu einer akustischen Schwingung angeregt wird. Wie zuvor beschrieben, kann damit eine gewünschte optische Korrekturwirkung erreicht werden.

Fig. 26B zeigt die beiden optischen Elemente 2152, 2154 von Fig. 26A, die hier als Planparallelplatte und als Linse ausgebildet sind. Das erste optische Element 2152 weist einen hohen Widerstand auf, d.h. es ist elektrisch isolierend, und das zweite optische Element 2154, das in Lichtdurchtrittsrichtung stromabwärts des optischen Elements 2152 angeordnet ist, ist elektrisch leitend. Eine Induzierung bzw. gezielte Aufbringung von elektrischen Ladungen auf das erste optische Element 2152 mittels eines geladenen Stabs führt zu einer An- bzw. Abstoßung von lokalen Bereichen des optischen Elements 2152 vom zweiten optischen Element 2154. Das Gas in dem Zwischenraum 2158 erfährt eine entsprechende Dichtemodulation. Zusätzlich wird das Gas des Zwischenraums 2158 durch die an dem Zwischenraum 2158 angeordnete Vorrichtung 2164 in Schwingung versetzt. Die Dichtevariation des Gases resultiert in einer lokalen Änderung des Brechungsindexes des Gases, wodurch ein Wellenfrontverlauf eines geeignet getakteten Lichtpulses, der durch das Gas hindurchtritt, gezielt beeinflusst werden kann.

Anstelle von Argon kann der Zwischenraum 2158 auch mit einer Flüssigkeit, beispielsweise Wasser, gefüllt sein.

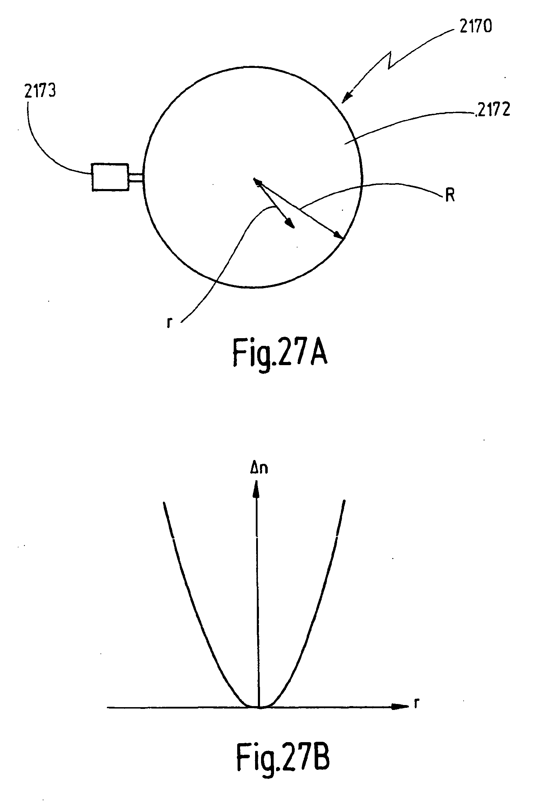

Fig. 27A zeigt eine Draufsicht auf ein optisches Element 2170, das als kreisförmige Quarzplatte 2172 mit Radius R ausgebildet ist und beispielsweise im Projektionsobjektiv der Projektionsbelichtungsanlage aufgenommen ist. Das optische Element 2170 kann ebenfalls in der Beleuchtungsoptik der Projektionsbelichtungsanlage aufgenommen sein.

Das optische Element 2170 ist mittels eines Schallerzeugers 2173 in Schwingung versetzbar, wodurch sich eine Schallwelle in dem optischen Element 2170 ausbreitet. Diese Schallwelle führt zu longitudinalen Dichtewellen, die sich im optischen Element 2170 ausbreiten und ein gerichtetes Spannungsfeld erzeugen, was wiederum die Doppelbrechungseigenschaften des optischen Elements lokal beeinflusst. In der Grundmode nimmt die resultierende Doppelbrechung des optischen Elements mit dem Radius r der Kreisscheibe radial nach außen zum Rand des optischen Element 2170 (vgl. Fig. 27B) ab. Die Hauptachsen der Doppelbrechung sind radial und tangential orientiert.

Es ist ebenfalls möglich, dass das optische Element 2170 als Depolarisator für den Polarisationszustand der Wellenfront der Lichtpulse der Lichtquelle wirkt. Bei geeigneter Synchronisierung der Schwingungsfrequenz des optischen Elements 2170 und der Pulsfrequenz der Lichtpulse wirkt das optische Element 2170 als schnell schaltbare $\lambda/2$-Platte, die zwischen zwei Laserpulsen den Polarisationszustand um 90° verändert bzw. verkippt. Die Laserpulse fallen hierzu abwechselnd auf ein Minimum und ein Maximum des Spannungsfeldes im Material des optischen Elements 2170.

Je nach Verwendung des in Schwingungen versetzbaren optischen Elements 2170 können sowohl die Beleuchtungsweise als auch die Abbildungseigenschaften der Projektionsbelichtungsanlage dynamisch beeinflusst und gezielt verändert werden, um ihre Abbildungsqualität zu verbessern und auftretende Abbildungsfehler zu korrigieren. Es können insbesondere Abberationen des Wellenfrontverlaufs der Lichtpulse der Lichtquelle kompensiert werden oder auch der Abbildungskontrast durch eine Anpassung des (lokalen) Polarisationszustands an die abzubildende Struktur optimiert werden. Eine Verwendung des optischen Elements 2170 in der Beleuchtung ermöglicht beispielsweise eine Generierung von rotationssymmetrischen Beleuchtungsweisen des Projektionsobjektivs und eine Manipulation der Kohärenzeigenschaften und der Polarisation der Lichtpulse der Lichtquelle.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind.

Die folgenden Sätze bilden einen Teil der vorliegenden Beschreibung, stellen jedoch keine Ansprüche der, in Übereinstimmung mit der Entscheidung J15/88 der Juristischen Beschwerdekammer des Europäischen Patentamts.

(1) Optische Vorrichtung mit einer Lichtquelle, die Licht in Form von Lichtpulsen mit einer Pulsfrequenz abstrahlt, und mit mindestens einem optischen Element, das mit Vorrichtungen zur Anregung einer Schwingung des optischen Elements mit einer Schwingungsfrequenz verbunden ist, wobei die Schwingung des optischen Elements zu einer zeitlich periodischen Modulation zumindest eines für die optische Abbildung relevanten Parameters des optischen Elements führt, wobei die Schwingungsfrequenz mittels der Vorrichtungen zur Anregung einer Schwingung des optischen Elements so einstellbar ist, dass sie mit der Pulsfrequenz der Lichtquelle synchronisiert ist, und wobei ein Taktgeber für die Pulsfrequenz der Lichtpulse vorgesehen ist, wobei mit dem Taktgeber zumindest ein Frequenzvervielfacher verbunden ist, dessen Ausgang mit den Vorrichtungen zur Erzeugung einer Schwingung verbunden ist.

(2) Optische Vorrichtung nach Satz (1), wobei die Schwingungsfrequenz des optischen Elements als ganzzahliges Vielfaches der Pulsfrequenz der Lichtquelle einstellbar ist.

(3) Optische Vorrichtung nach Satz (1), wobei die Schwingung des optischen Elements eine Überlagerung von Schwingungen mit unterschiedlichen ganzzahligen Vielfachen der Pulsfrequenz ist.

(4) Optische Vorrichtung nach einem der Sätze (1) bis (3), wobei die Schwingungsfrequenz des optischen Elements phasenverschoben zur Pulsfrequenz der Lichtquelle einstellbar ist.

(5) Optische Vorrichtung nach Satz (3), wobei den unterschiedlichen ganzzahligen Vielfachen der Pulsfrequenz jeweils eine Phasenverschiebung zugeordnet ist.

(6) Optische Vorrichtung nach Satz (5), wobei die Phasenverschiebung einstellbar ist.

(7) Optische Vorrichtung nach einem der Sätze (3), (5) oder (6), wobei den unterschiedlichen ganzzahligen Vielfachen der Pulsfrequenz jeweils eine Schwingungsamplitude zugeordnet ist.

(8) Optische Vorrichtung nach Satz (7), wobei die Amplitude einstellbar ist.

(9) Optische Vorrichtung nach einem der Sätze (1) bis (8), wobei mit dem Taktgeber zumindest ein Phasenschieberglied verbunden ist, dessen Ausgang mit den Vorrichtungen zur Anregung einer Schwingung verbunden ist.

(10) Optische Vorrichtung nach einem der Sätze (1) bis (9), wobei eine Mehrzahl an Frequenzvervielfachern und/oder Phasenschiebergliedern mit dem Taktgeber verbunden sind, deren Ausgänge mit einem Summierglied verbunden sind, dessen Ausgang mit den Vorrichtungen zur Anregung einer Schwingung verbunden ist.

(11) Optische Vorrichtung nach einem der Sätze (1) bis (10), wobei die Vorrichtungen zur Anregung einer Schwingung und das optische Element dazu ausgelegt sind, eine transversale Schwingung des optischen Elements anzuregen.

(12) Optische Vorrichtung nach einem der Sätze (1) bis (11), wobei die Vorrichtungen zur Anregung einer Schwingung und das optische Element dazu ausgelegt sind, eine longitudinale Schwingung des optischen Elements anzuregen.

(13) Optische Vorrichtung nach einem der Sätze (1) bis (12), wobei das optische Element einen kristallinen Festkörper, einen amorphen Festkörper, eine Flüssigkeit oder ein Gas aufweist.

(14) Optische Vorrichtung nach einem der Sätze (1) bis (13), wobei das optische Element doppelbrechendes Material aufweist.

(15) Optische Vorrichtung nach einem der Sätze (1) bis (14), wobei das optische Element zwischen zwei Festkörperschichten eine Flüssigkeits- oder Gasschicht aufweist, wobei die Flüssigkeits- oder Gasschicht zur Schwingung anregbar ist.

(16) Optische Vorrichtung nach einem der Sätze (1) bis (14), wobei das optische Element zwischen zwei Festkörperschichten eine Flüssigkeits- oder Gasschicht aufweist, wobei zumindest eine der zwei Festkörperschichten zur Schwingung anregbar ist.

(17) Optische Vorrichtung nach einem der Sätze (1) bis (16), wobei die optische Vorrichtung eine Pupillenebene aufweist und das optische Element in der Pupillenebene oder im Bereich der Pupillenebene angeordnet ist.

(18) Optische Vorrichtung nach einem der Sätze (1) bis (16), wobei die optische Vorrichtung eine Feldebene aufweist und das optische Element in der Feldebene oder im Bereich der Feldebene angeordnet ist.

(19) Optische Vorrichtung nach einem der Sätze (1) bis (18), wobei die Vorrichtungen zur Anregung einer elastischen Schwingung des optischen Elements Lautsprecher, Tauchspulen, Piezoaktuatoren, elektrostatische, magnetostatische, hydraulisch gesteuerte oder pneumatisch gesteuerte Aktuatoren umfassen.

(20) Optische Vorrichtung nach einem der Sätze (1) bis (19), wobei die Vorrichtungen zur Anregung von Schwingungen des optischen Elements im Abschattungsbereich des optischen Elements angeordnet sind.

(21) Optische Vorrichtung nach Satz (20), wobei die Vorrichtungen zur Anregung von Schwingungen des optischen Elements am Umfang des optischen Elements angeordnet sind.

(22) Optische Vorrichtung nach Satz (20), wobei das optische Element ein zentrales Mittenloch aufweist, in dem weitere Vorrichtungen zur Anregung von Schwingungen des optischen Elements angeordnet sind.

(23) Optische Vorrichtung nach einem der Sätze (1) bis (22), wobei das optische Element mit den Vorrichtungen zur Anregung von Schwingungen gegenüber der Umgebung im wesentlichen schwingungsentkoppelt ist.

(24) Optische Vorrichtung nach Satz (23), wobei die optische Vorrichtung neben dem optischen Element mindestens ein weiteres optisches Element umfasst, wobei für das optische Element eine erste Trägerstruktur und für das mindestens eine weitere optische Element eine zweite Trägerstruktur vorgesehen ist, wobei die erste und die zweite Trägerstruktur derart voneinander entkoppelt sind, dass von der ersten Trägerstruktur keine Kraftübertragung auf die zweite Trägerstruktur möglich ist.

(25) Optische Vorrichtung nach Satz (23), wobei die Schwingungsentkopplung mittels zu Schwingungen anregbaren Ausgleichselementen erfolgt.

(26) Optische Vorrichtung nach einem der Sätze (1) bis (25), wobei die Lichtquelle ein Stroboskop, eine Laserlichtquelle, ein Synchrotron, eine gechoppte Lichtquelle, eine elektronisch schaltbare Lichtquelle (Lampe, Diode), eine CW-Lichtquelle mit Shutter, oder eine Plasmaquelle ist.

(27) Optische Vorrichtung nach einem der Sätze (1) bis (26), wobei das optische Element eine Planplatte, insbesondere eine Membran, ist.

(28) Optische Vorrichtung nach einem der Sätze (1) bis (26), wobei das optische Element ein Spiegel ist.

(29) Optische Vorrichtung nach einem der Sätze (1) bis (26), wobei das optische Element aus einer Flüssigkeit mit einer reflektierenden Oberfläche besteht.

(30) Optische Vorrichtung nach einem der Sätze (1) bis (26), wobei das optische Element eine Linse ist.

(31) Optische Vorrichtung nach Satz (30), wobei das optische Element eine Flüssiglinse ist.

(32) Optische Vorrichtung nach einem der Sätze (1) bis (26), wobei das optische Element aus einem Array einzelner optischer Komponenten besteht.

(33) Optische Vorrichtung nach Satz (32), wobei die einzelnen optischen Komponenten Linsen, Spiegel, Gitter und/oder flache, insbesondere planparallele, abschnitts- und/oder zonenweise brechende Linsensegmente umfassen.

(34) Optische Vorrichtung nach Satz (32) oder (33), wobei die einzelnen optischen Komponenten gleiche Geometrien aufweisen.

(35) Optische Vorrichtung nach Satz (32) oder (33), wobei die einzelnen optischen Komponenten unterschiedliche Geometrien aufweisen.

(36) Optische Vorrichtung nach einem der Sätze (32) bis (35), wobei die einzelnen optischen Komponenten mittels Verbindungselementen miteinander verbunden sind, wobei mindestens zwei Verbindungselemente unterschiedliche Elastizitätseigenschaften aufweisen.

(37) Optische Vorrichtung nach einem der Sätze (1) bis (26), wobei das optische Element als zumindest ein gasbefüllter Teilraum der optischen Vorrichtung ausgebildet ist.

33 **EP 2 044 487 B1** 34

(38) Optische Vorrichtung nach einem der Sätze (1) bis (37), wobei die optische Vorrichtung zumindest zwei voneinander beabstandete optische Elemente aufweist, zwischen denen ein Zwischenraum mit Gas oder Flüssigkeit angeordnet ist.

(39) Optische Vorrichtung nach Satz (38), wobei eines der zwei optischen Elemente, die zwei optischen Elemente und/oder der Zwischenraum mit Gas oder Flüssigkeit zu einer Schwingung anregbar sind.

(40) Optische Vorrichtung nach Satz (38) oder (39), wobei ein erstes optisches Element der zwei optischen Elemente elektrisch isolierend und ein zweites optisches Element der zwei optischen Elemente elektrisch leitend ausgebildet ist.

(41) Optische Vorrichtung nach einem der Sätze (1) bis (40), wobei die Elastizitätseigenschaften, wie Steifigkeit oder Dämpfungsverhalten, des optischen Elements lokal variieren.

(42) Optische Vorrichtung nach einem der Sätze (1) bis (41), wobei das optische Element eine von seiner Mitte bis zu seinem Rand hin lokal variierende Dicke aufweist.

(43) Optische Vorrichtung nach einem der Sätze (1) bis (42), wobei die optische Vorrichtung eine Kontrolleinheit aufweist, welche ein Messsystem, ein Auswertesystem und ein Kontrollsystem umfasst.

(44) Optische Vorrichtung nach Satz (43), wobei das Messsystem einen oder mehrere Fokussensoren, ein Interferometer mit getakteter Beleuchtung, eine Polarisationsmesseinheit oder eine Anordnung von Mikrophonen oder Beschleunigungssensoren zur Messung von Kontrollparametern des optischen Elements umfasst.

(45) Optische Vorrichtung nach Satz (43) oder (44), wobei das Messsystem einen Wellenfrontsensor, insbesondere ein Interferometer mit mehreren parallel arbeitenden Messkanälen zur synchronen Messung an mehreren Feldpunkten, zur Messung von Kontrollparametern der gesamten optischen Vorrichtung umfasst.

(46) Optische Vorrichtung nach einem der Sätze (43) bis (45), wobei das Messsystem einen polarimetrischen Sensor mit parallel arbeitenden Messkanälen zur synchronen Messung des Polarisationszustandes des Lichtwellenfeldes an mehreren Feldpunkten umfasst, um die Kontrollparameter für die gesamte optische Vorrichtung zu bestimmen.

(47) Optische Vorrichtung nach einem der Sätze (43) bis (46), wobei das Kontrollsystem ein Synchronisationssystem zur Synchronisierung der Schwingungsfrequenz der Schwingung des optischen Elements mit der Pulsfrequenz der Lichtquelle umfasst.

(48) Optische Vorrichtung nach einem der Sätze (1) bis (47), wobei die optische Vorrichtung mindestens ein weiteres manipulierbares optisches Element enthält, welches insbesondere verschiebbar, verkippbar oder statisch verformbar ausgestaltet ist.

(49) Projektionsbelichtungsanlage mit einer optischen Vorrichtung nach einem der Sätze (1) bis (48).

(50) Projektionsbelichtungsanlage nach Satz (49), wobei die Projektionsbelichtungsanlage ein Beleuchtungssystem aufweist und das optische Element innerhalb des Beleuchtungssystems angeordnet ist.

(51) Projektionsbelichtungsanlage nach Satz (49) oder (50), wobei die Projektionsbelichtungsanlage ein Projektionsobjektiv aufweist und das optische Element innerhalb des Projektionsobjektivs angeordnet ist.

(52) Verfahren zur Korrektur bzw. Verbesserung des Abbildungsverhaltens einer optischen Vorrichtung, insbesondere einer Projektionsbelichtungsanlage, welche eine gepulste Lichtquelle mit einer Pulsfrequenz aufweist, wobei mindestens ein optisches Element zu einer Schwingung mit einer Schwingungsfrequenz angeregt wird, wobei die Schwingung des optischen Elements zu einer zeitlich periodischen Modulation zumindest eines für die optische Abbildung relevanten Parameters des optischen Elements führt, wobei die Schwingungsfrequenz der Schwingung des optischen Elements so eingestellt wird, dass sie mit der Pulsfrequenz der Lichtquelle synchronisiert ist, wobei die Schwingungsfrequenz des optischen Elements als ganzzahliges Vielfaches der Pulsfrequenz eingestellt wird.

(53) Verfahren nach Satz (52), wobei die Schwingung des optischen Elements als Überlagerung von Schwingungen mit unterschiedlichen ganzzahligen Vielfachen der Pulsfrequenz angeregt wird.

(54) Verfahren nach Satz (52) oder (53), wobei die Schwingungsfrequenz des optischen Elements phasenverschoben zur Pulsfrequenz der Lichtquelle eingestellt wird.

(55) Verfahren nach Satz (53), wobei den unterschiedlichen ganzzahligen Vielfachen der Pulsfrequenz jeweils eine Phasenverschiebung zugeordnet wird.

(56) Verfahren nach Satz (55), wobei die Phasenverschiebung eingestellt wird.

(57) Verfahren nach Satz (53), (55) oder (56), wobei den unterschiedlichen ganzzahligen Vielfachen der Pulsfrequenz jeweils eine Schwingungsamplitude zugeordnet wird.

(58) Verfahren nach Satz (57), wobei die Schwingungsamplitude eingestellt wird.

(59) Verfahren nach einem der Sätze (52) bis (58), wobei mittels eines Taktgebers für die Pulsfrequenz der Lichtpulse ein Taktsignal erzeugt wird, wobei das Taktsignal einem Frequenzvervielfacher und zumindest einem Phasenschieberglied zugeführt wird, deren Ausgangssignal zur Anregung einer Schwingung des optischen Elements verwendet wird.

(60) Verfahren nach Satz (59), wobei das Taktsignal einer Mehrzahl an Frequenzvervielfachern und Phasenschiebergliedern zugeführt wird, deren Ausgangssignale einem Summierglied zugeführt werden, dessen Ausgangssignal zur Anregung der Schwingungen des optischen Elements verwendet wird.

(61) Verfahren nach einem der Sätze (52) bis (60), wobei das optische Element zu einer transversalen Schwingung angeregt wird.

(62) Verfahren nach einem der Sätze (52) bis (61), wobei das optische Element zu einer longitudinalen Schwingung angeregt wird.

(63) Verfahren nach einem der Sätze (52) bis (62), wobei das optische Element zwischen zwei Festkörperschichten eine Flüssigkeits- oder Gasschicht aufweist, wobei die Flüssigkeits- oder Gasschicht zur Schwingung angeregt wird.

(64) Verfahren nach einem der Sätze (52) bis (62), wobei das optische Element zwischen zwei Festkörperschichten eine Flüssigkeits- oder Gasschicht aufweist, wobei zumindest eine der zwei Festkörperschichten zur Schwingung angeregt wird.

(65) Verfahren nach einem der Sätze (52) bis (64), wobei die optische Vorrichtung zumindest zwei voneinander beabstandete optische Elemente aufweist, zwischen denen ein Zwischenraum mit Gas oder Flüssigkeit angeordnet ist, wobei eines der zwei optischen Elemente, die zwei optischen Elemente und/oder der Zwischenraum mit Gas oder Flüssigkeit zur Schwingung angeregt wird.

(66) Verfahren nach Satz (65), wobei ein erstes optisches Element der zwei optischen Elemente elektrisch isolierend und ein zweites optisches Element der zwei optischen Elemente elektrisch leitend ausgebildet ist, wobei das erste optische Element mit elektrischen Ladungen beaufschlagt wird.

(67) Verfahren nach einem der Sätze (52) bis (66), wobei in einem ersten Schritt in einer Feldebene der optischen Vorrichtung eine Wellenfront der optischen Vorrichtung ermittelt wird, in einem zweiten Schritt die ermittelte Wellenfront mit einer vorgegebenen Wellenfront verglichen wird, in einem dritten Schritt eine Differenz zwischen der ermittelten Wellenfront und der vorgegebenen Wellenfront bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen der ermittelten Wellenfront und der vorgegebenen Wellenfront minimiert wird, und in einem fünften Schritt das optische Element zur Schwingung in dieser Schwingungsmode angeregt wird.

(68) Verfahren nach einem der Sätze (52) bis (66), wobei in einem ersten Schritt in einer Feldebene der optischen Vorrichtung der Polarisationszustand des Lichtwellenfeldes, das durch die optische Vorrichtung erzeugt wird, bestimmt wird, in einem zweiten Schritt der ermittelte Polarisationszustand mit einer vorgegebenen Polarisationszustandsverteilung verglichen wird, in einem dritten Schritt eine Differenz zwischen dem ermittelten Polarisationszustand und dem vorgegebenen Polarisationszustand bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen dem ermittelten Polarisationszustand und dem vorgegebenen Polarisationszustand minimiert wird, und in einem fünften Schritt das optische Element zur Schwingung in dieser Schwingungsmode angeregt wird.

(69) Verfahren gemäß einem der Sätze (52) bis (66), wobei in einem ersten Schritt in einer Feldebene eine Winkelverteilung der Intensität der Strahlung der Lichtquelle ermittelt wird, in einem zweiten Schritt die ermittelte Winkelverteilung mit einer vorgegebenen Winkelverteilung verglichen wird, in einem dritten Schritt eine Differenz zwischen der ermittelten Winkelverteilung und der vorgegebenen Winkelverteilung bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen der ermittelten Winkelverteilung und der vorgegebenen Winkelverteilung minimiert wird, und in einem fünften Schritt das optische Element zur Schwingung in dieser Schwingungsmode angeregt wird.

(70) Verfahren nach einem der Sätze (52) bis (66), wobei in einem ersten Schritt in einer Feldebene eine Intensitätsverteilung der Strahlung der Lichtquelle ermittelt wird, in einem zweiten Schritt die ermittelte Intensitätsverteilung mit einer vorgegebenen Intensitätsverteilung verglichen wird, in einem dritten Schritt eine Differenz zwischen der ermittelten Intensitätsverteilung und der vorgegebenen Intensitätsverteilung bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen der ermittelten Intensitätsverteilung und der vorgegebenen Intensitätsverteilung minimiert wird, und in einem fünften Schritt das optische Element zur Schwingung in dieser Schwingungsmode angeregt wird.

(71) Verfahren nach einem der Sätze (52) bis (66), wobei in einem ersten Schritt in einer Austrittspupille der optischen Vorrichtung eine Intensitätsverteilung der Strahlung der Lichtquelle ermittelt wird, in einem zweiten Schritt die ermittelte Intensitätsverteilung mit einer vorgegebenen Intensitätsverteilung verglichen wird, in einem dritten Schritt eine Differenz zwischen der ermittelten Intensitätsverteilung und der vorgegebenen Intensitätsverteilung bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen der ermittelten Intensitätsverteilung und der vorgegebenen Intensitätsverteilung minimiert wird, und in einem fünften Schritt das optische Element zur Schwingung in dieser Schwingungsmode angeregt wird.

(72) Verfahren nach einem der Sätze (52) bis (66), wobei in einem ersten Schritt in einer Austrittspupille der optischen Vorrichtung eine Polarisationszustandsverteilung der Strahlung der Lichtquelle ermittelt wird, in einem zweiten Schritt die ermittelte Polarisationszustandsverteilung mit einer vorgegebenen Polarisationszustandsverteilung verglichen wird, in einem dritten Schritt eine Differenz zwischen der ermittelten Polarisationszustandsverteilung und der vorgegebenen Polarisationszustandsverteilung bestimmt wird, in einem vierten Schritt eine Schwingungsmode des optischen Elements bestimmt wird, welche so gestaltet ist, dass bei Synchronisation der Schwingungsfrequenz des optischen Elements mit der Pulsfrequenz der Lichtquelle die Differenz zwischen der ermittelten Polarisationszustandsverteilung und der vorgegebenen Polarisationszustandsverteilung minimiert wird, und in einem fünften Schritt das optische Element zur Schwingung in dieser Schwingungsmode angeregt wird.

(73) Verfahren nach einem der Sätze (52) bis (72), wobei die Schwingung des optischen Elements mittels Vorrichtungen zur Anregung von Schwingungen des optischen Elements angeregt werden, wobei eine Kontrolleinheit Kontrollparameter des schwingenden optischen Elements misst, diese Kontrollparameter mit vorgegebenen Sollwerten vergleicht, um ein Auswerteergebnis zu erhalten, und die Vorrichtungen zur Anregung von Schwingungen des optischen Elements anhand des Auswerteergebnisses regelt.

(74) Verfahren nach Satz (73), wobei die Kontrollparameter mit mindestens einem Fokussensor oder mit einem Interferometer mit getakteter Beleuchtung, einem Polarimeter oder mit einer Anordnung von Mikrophonen gemessen werden.

## Patentansprüche

1.  Optische Vorrichtung mit einer Lichtquelle (3; 1812), die Licht in Form von Lichtpulsen mit einer Pulsfrequenz abstrahlt, und mit mindestens einem optischen Element (31; 1814), das mit Vorrichtungen (1818) zur Anregung einer Schwingung des optischen Elements (31; 1814) mit einer Schwingungsfrequenz verbunden ist, wobei die Schwingung des optischen Elements (31; 1814) zu einer zeitlich periodischen Modulation zumindest eines für die optische Abbildung relevanten Parameters des optischen Elements (31; 1814) führt, wobei die Schwingungsfrequenz mittels der Vorrichtungen (1818) zur Anregung einer Schwingung des optischen Elements (31; 1814) so einstellbar ist, dass sie mit der Pulsfrequenz der Lichtquelle (3; 1812) synchronisiert ist, und wobei ein Taktgeber (1820) für die Pulsfrequenz der Lichtpulse vorgesehen ist, wobei mit dem Taktgeber (1820) zumindest ein Frequenzvervielfacher (1822i) verbunden ist, dessen Ausgang mit den Vorrichtungen (1818) zur Erzeugung einer Schwingung verbunden ist, **dadurch gekennzeichnet, dass** das optische Element (31; 1814) aus einem Array (1131; 1231; 1331; 1431) einzelner optischer Komponenten besteht.

2.  Optische Vorrichtung nach Anspruch 1, **dadurch gekennzeichnet, dass** mit dem Taktgeber (1820) zumindest ein Phasenschieberglied (1824i) verbunden ist, dessen Ausgang mit den Vorrichtungen (1818) zur Anregung einer Schwingung verbunden ist.

3.  Optische Vorrichtung nach Anspruch 1 oder 2, **dadurch gekennzeichnet, dass** eine Mehrzahl an Frequenzvervielfachern (1822i) und/oder Phasenschiebergliedern (1824i) mit dem Taktgeber (1820) verbunden sind, deren Ausgänge mit einem Summierglied (1828) verbunden sind, dessen Ausgang mit den Vorrichtungen (1818) zur Anregung einer Schwingung verbunden ist.

4.  Optische Vorrichtung nach einem der Ansprüche 1 bis 3, **dadurch gekennzeichnet, dass** die Vorrichtungen (1818) zur Anregung einer Schwingung und das optische Element (31; 1814) dazu ausgelegt sind, eine transversale Schwingung und/oder eine longitudinale Schwingung des optischen Elements (31; 1814) anzuregen.

5.  Optische Vorrichtung nach einem der Ansprüche 1 bis 4, **dadurch gekennzeichnet, dass** das optische Element (31; 1814) einen kristallinen Festkörper, einen amorphen Festkörper, eine Flüssigkeit oder ein Gas aufweist.

6.  Optische Vorrichtung nach einem der Ansprüche 1 bis 5, **dadurch gekennzeichnet, dass** das optische Element (31; 1814) doppelbrechendes Material aufweist.

7.  Optische Vorrichtung nach einem der Ansprüche 1 bis 6, **dadurch gekennzeichnet, dass** die optische Vorrichtung (1; 1810) eine Pupillenebene oder eine Feldebene aufweist und das optische Element in der Pupillenebene oder im Bereich der Pupillenebene oder in der Feldebene oder im Bereich der Feldebene angeordnet ist.

8.  Optische Vorrichtung nach einem der Ansprüche 1 bis 7, **dadurch gekennzeichnet, dass** die Vorrichtungen (1818) zur Anregung einer elastischen Schwingung des optischen Elements (31; 1814) Lautsprecher, Tauchspulen, Piezoaktuatoren, elektrostatische, magnetostatische, hydraulisch gesteuerte oder pneumatisch gesteuerte Aktuatoren umfassen.

9.  Optische Vorrichtung nach einem der Ansprüche 1 bis 8, **dadurch gekennzeichnet, dass** die Vorrichtungen (1818) zur Anregung von Schwingungen des optischen Elements (31; 1814) im Abschattungsbereich des optischen Elements (31; 1814), insbesondere am Umfang des optischen Elements (31; 1814), angeordnet sind, oder wobei das optische Element (31; 1814) ein zentrales Mittenloch aufweist, in dem weitere Vorrichtungen zur Anregung von Schwingungen des optischen Elements (31; 1814) angeordnet sind.

10. Optische Vorrichtung nach einem der Ansprüche 1 bis 9, **dadurch gekennzeichnet, dass** die Lichtquelle (3; 1812) ein Stroboskop, eine Laserlichtquelle, ein Synchrotron, eine gechoppte Lichtquelle, eine elektronisch schaltbare Lichtquelle (Lampe, Diode), eine CW-Lichtquelle mit Shutter, oder eine Plasmaquelle ist.

11. Optische Vorrichtung nach einem der Ansprüche 1 bis 10, **dadurch gekennzeichnet, dass** das optische Element (31; 1814) eine Planplatte, insbesondere eine Membran, oder ein Spiegel ist, oder aus einer Flüssigkeit mit einer reflektierenden Oberfläche besteht, oder eine Linse, insbesondere eine Flüssiglinse ist.

12. Optische Vorrichtung nach einem der Ansprüche 1 bis 11, **dadurch gekennzeichnet, dass** die einzelnen optischen Komponenten des Arrays (1131; 1231; 1331; 1431) insbesondere Linsen, Spiegel, Gitter und/oder flache, insbesondere planparallele, abschnitts- und/oder zonenweise brechende Linsensegmente umfassen, wobei die einzelnen optischen Komponenten gleiche Geometrien oder unterschiedliche Geometrien aufweisen können.

13. Optische Vorrichtung nach einem der Ansprüche 1 bis 12, **dadurch gekennzeichnet, dass** die einzelnen optischen Komponenten des Arrays (1131; 1231; 1331; 1431) mittels Verbindungselementen (1163; 1363; 1463) miteinander verbunden sind, wobei mindestens zwei Verbindungselemente (1163; 1363; 1463) unterschiedliche Elastizitätseigenschaften aufweisen.

14. Optische Vorrichtung nach einem der Ansprüche 1 bis 13, **dadurch gekennzeichnet, dass** die optische Vorrichtung (1; 1810) zumindest zwei voneinander beabstandete optische Elemente (2152, 2154) aufweist, zwischen denen ein Zwischenraum (2158) mit Gas oder Flüssigkeit angeordnet ist, wobei vorzugsweise eines der zwei optischen Elemente (2152, 2154), die zwei optischen Elemente (2152, 2154) und/oder der Zwischenraum (2158) mit Gas oder Flüssigkeit zu einer Schwingung anregbar sind, und/oder wobei vorzugsweise ein erstes optisches Element der zwei optischen Elemente (2152, 2154) elektrisch isolierend und ein zweites optisches Element der zwei optischen Elemente (2152, 2154) elektrisch leitend ausgebildet ist.

15. Optische Vorrichtung nach einem der Ansprüche 1 bis 14, **dadurch gekennzeichnet, dass** die optische Vorrichtung (1; 1810) eine Kontrolleinheit (35) aufweist, welche ein Messsystem, ein Auswertesystem und ein Kontrollsystem umfasst, wobei das Messsystem vorzugsweise einen oder mehrere Fokussensoren, ein Interferometer mit getakteter Beleuchtung, eine Polarisationsmesseinheit oder eine Anordnung von Mikrophonen oder Beschleunigungssensoren zur Messung von Kontrollparametern des optischen Elements umfasst, und/oder wobei das Messsystem vorzugsweise einen Wellenfrontsensor, insbesondere ein Interferometer mit mehreren parallel arbeitenden Messkanälen zur synchronen Messung an mehreren Feldpunkten, zur Messung von Kontrollparametern der gesamten optischen Vorrichtung umfasst, und/oder wobei das Messsystem vorzugsweise einen polarimetrischen Sensor mit parallel arbeitenden Messkanälen zur synchronen Messung des Polarisationszustandes des Lichtwellenfeldes an mehreren Feldpunkten umfasst, um die Kontrollparameter für die gesamte optische Vorrichtung zu bestimmen, und/oder wobei das Kontrollsystem vorzugsweise ein Synchronisationssystem zur Synchronisierung der Schwingungsfrequenz der Schwingung des optischen Elements mit der Pulsfrequenz der Lichtquelle umfasst.

16. Optische Vorrichtung nach einem der Ansprüche 1 bis 15, **dadurch gekennzeichnet, dass** die optische Vorrichtung (1; 1810) mindestens ein weiteres manipulierbares optisches Element enthält, welches insbesondere verschiebbar, verkippbar oder statisch verformbar ausgestaltet ist.

## Claims

1. An optical apparatus, comprising a light source (3; 1812) that emits light in the form of light pulses having a pulse frequency, and comprising at least one optical element (31; 1814) connected to apparatuses (1818) for the excitation of an oscillation of the optical element (31; 1814) with an oscillation frequency, wherein the oscillation of the optical element (31; 1814) leads to a temporally periodic modulation of at least one parameter of the optical element (31; 1814) that is relevant to the optical imaging, wherein the oscillation frequency can be set by means of the apparatuses (1818) for the excitation of an oscillation of the optical element (31; 1814) such that it is synchronized with the pulse frequency of the light source (3; 1812), and wherein a clock generator (1820) for the pulse frequency of the light pulses is provided, wherein at least one frequency multiplier (1822i) is connected to the clock generator, the output of said at least one frequency multiplier being connected to the apparatuses (1818) for generating an oscillation, **characterized in that** the optical element (31; 1814) comprises an array of individual optical components.

2. The optical apparatus of claim 1, **characterized in that** at least one phase shifter element (1824i) is connected to the clock generator (1820), the output of said at least one phase shifter element being connected to the apparatuses (1818) for the excitation of an oscillation.

3. The optical apparatus of claim 1 or 2, **characterized in that** a plurality of frequency multipliers (1822i) and/or phase shifter elements (1824i) are connected to the clock generator (1820), and their outputs are connected to a summation element (1828), the output of which is connected to the apparatuses (1818) for the excitation of an oscillation.

4. The optical apparatus of anyone of claims 1 to 3, **characterized in that** the apparatuses (1818) for the excitation of an oscillation and the optical element (31; 1814) are designed to excite a transverse oscillation and/or a longitudinal oscillation of the optical element.

5. The optical apparatus of anyone of claims 1 to 4, **characterized in that** the optical element (31; 1814) comprises a crystalline solid, an amorphous solid, a liquid or a gas.

6. The optical apparatus of anyone of claims 1 to 5, **characterized in that** the optical element (31; 1814) comprises birefringent material.

7. The optical apparatus of anyone of claims 1 to 6, **characterized in that** the optical apparatus (1; 1810) has a pupil plane or a field plane and the optical element is arranged in the pupil plane or in the region of the pupil plane or in the field plane or in the region of the field plane.

8. The optical apparatus of anyone of claims 1 to 7, **characterized in that** the apparatuses (1818) for the excitation of an elastic oscillation of the optical element (31; 1814) comprise loudspeakers, plunger-type coils, piezeoactuators, electrostatic, magnetostatic, hydraulically controlled or pneumatically controlled actuators.

9. The optical apparatus of anyone of claims 1 to 8, **characterized in that** the apparatuses (1818) for the excitation of oscillations of the optical element (31; 1814) are arranged in the shading region of the optical element (31; 1814), in particular at the periphery of the optical element (31; 1814), or wherein the optical element (31; 1814) has a central middle hole in which are arranged further apparatuses for the excitation of oscillations of the optical element (31; 1814).

10. The optical apparatus of anyone of claims 1 to 9, **characterized in that** the light source (3; 1812) is a stroboscope, a laser light source, a synchrotron, a chopped light source, an electronically switchable light source (lamp, diode), a CW light source with shutter, or a plasma source.

11. The optical apparatus of anyone of claims 1 to 10, **characterized in that** the optical element (31; 1814) is a plane plate, in particular a membrane, or a mirror, or comprises a liquid having a reflective surface, or is a lens, in particular a liquid lens.

12. The optical apparatus of anyone of claims 1 to 11, **characterized in that** the individual optical components of the array (1131; 1231; 1331; 1431) in particular comprise lenses, mirrors, gratings and/or flat, in particular plane-parallel, lens segments that are refractive in sections and/or in zones, wherein the individual optical components have identical geometries or different geometries.

13. The optical apparatus of anyone of claims 1 to 12, **characterized in that** the individual optical components of the array (1131; 1231; 1331; 1431) are connected to one another by means of connecting elements (1163; 1363; 1463), wherein at least two connecting elements (1163; 1363; 1463) have different elasticity properties.

14. The optical apparatus of anyone of claims 1 to 13, **characterized in that** the optical apparatus (1; 1810) has at least two optical elements (2152, 2154) which are spaced apart from one another and between which is arranged an interspace (2158) with gas or liquid, wherein, preferably, one of the two optical elements (2152, 2154), the two optical elements (2152, 2154) and/or the interspace (2158) with gas or liquid can be excited to oscillate, and/or wherein preferably a first optical element of the two optical elements (2152, 2154) is embodied in electrically insulating fashion and a second optical element (2152, 2154) of the two optical elements is embodied in electrically conductive fashion.

15. The optical apparatus of anyone of claims 1 to 14, **characterized in that** the optical apparatus (1; 1810) has a control unit (35) comprising a measuring system, an evaluation system and a control system, wherein the measuring system preferably comprises one or more focus sensors, an interferometer with clocked illumination, a polarization measuring unit or an arrangement of microphones or acceleration sensors for measuring control parameters of the optical element, and/or wherein the measuring system preferably comprises a wavefront sensor, in particular an interferometer with a plurality of measuring channels operating in parallel for synchronous measurement at a plurality of field points, for measuring control parameters of the entire optical apparatus, and/or wherein the measuring system preferably comprises a polarimetric sensor with measuring channels operating in parallel for the synchronous measurement of the polarization state of the light wave field at a plurality of field points in order to determine the control parameters for the entire optical apparatus, and/or wherein the control system preferably comprises a synchronization system for synchronizing the oscillation frequency of the oscillation of the optical element with the pulse frequency of the light source.

16. The optical apparatus of anyone of claims 1 to 15, **characterized in that** the optical apparatus (1; 1815) contains at least one further manipulatable optical element configured, in particular, in displaceable fashion, in tiltable fashion or in statically deformable fashion.

**Revendications**

1. Dispositif optique avec une source de lumière (3 ; 1812), laquelle émet de la lumière sous forme d'impulsions lumineuses avec une fréquence d'impulsion, et avec au moins un élément optique (31 ; 1814) qui est connecté à des dispositifs (1818) pour l'excitation d'une oscillation de l'élément optique (31; 1814) avec une fréquence d'oscillation, l'oscillation de l'élément optique (31 ; 1814) résultant en une modulation périodique dans le temps d'au moins un paramètre pertinent pour l'image optique de l'élément optique (31 ; 1814), la fréquence d'oscillation pouvant être réglée au moyen des dispositifs (1818) pour l'excitation d'une oscillation de l'élément optique (31 ; 1814) de manière à être synchronisée avec la fréquence d'impulsion de la source de lumière (3 ; 1812), et une horloge (1820) pour la fréquence d'impulsion des impulsions lumineuses étant prévue, au moins un multiplicateur de fréquence (1822i) étant connecté à l'horloge (1820), dont la sortie est connectée aux dispositifs (1818) pour la génération d'une oscillation, **caractérisé en ce que** l'élément optique (31 ; 1814) se compose d'un réseau (1131 ; 1231 ; 1331 ; 1431) de composants optiques individuels.

2. Dispositif optique selon la revendication 1, **caractérisé en ce qu'**au moins un organe de décalage de phase (1824i) est connecté à l'horloge (1820), dont la sortie est connectée aux dispositifs (1818) pour l'excitation d'une oscillation.

3. Dispositif optique selon la revendication 1 ou 2, **caractérisé en ce qu'**une pluralité de multiplicateurs de fréquence (1822i) et/ou d'organes de décalage de phase (1824i) est connectée à l'horloge (1820), dont les sorties sont connectées à un organe d'addition (1828), dont la sortie est connectée aux dispositifs (1818) pour l'excitation d'une oscillation.

**4.** Dispositif optique selon l'une quelconque des revendications 1 à 3, **caractérisé en ce que** les dispositifs (1818) pour l'excitation d'une oscillation et l'élément optique (31 ; 1804) sont étudiés pour l'excitation d'une oscillation transversale et/ou d'une oscillation longitudinale de l'élément optique (31 ; 1814).

**5.** Dispositif optique selon l'une quelconque des revendications 1 à 4, **caractérisé en ce que** l'élément optique (31 ; 1814) présente un solide cristallin, un solide amorphe, un liquide ou un gaz.

**6.** Dispositif optique selon l'une quelconque des revendications 1 à 5, **caractérisé en ce que** l'élément optique (31; 1814) présente un matériau biréfringeant.

**7.** Dispositif optique selon l'une quelconque des revendications 1 à 6, **caractérisé en ce que** le dispositif optique (1 ; 1810) présente un plan de la pupille ou un plan de champ, et **en ce que** l'élément optique est disposé dans le plan de la pupille ou dans la zone du plan de la pupille ou dans le plan de champ ou dans la zone du plan de champ.

**8.** Dispositif optique selon l'une quelconque des revendications 1 à 7, **caractérisé en ce que** les dispositifs (1818) pour l'excitation d'une oscillation élastique de l'élément optique (31 ; 1814) comprennent des haut-parleurs, des bobines en immersion, des actionneurs piézoélectriques, des actionneurs à commande électrostatique, magnétostatique, hydraulique ou à commande pneumatique.

**9.** Dispositif optique selon l'une quelconque des revendications 1 à 8, **caractérisé en ce que** les dispositifs (1818) pour l'excitation d'oscillations de l'élément optique (31 ; 1814) sont disposés dans la zone de projection d'ombre de l'élément optique (31 ; 1814), en particulier sur le pourtour de l'élément optique (31 ; 1814), ou bien **en ce que** l'élément optique (31 ; 1814) présente un trou du milieu central, dans lequel d'autres dispositifs pour l'excitation d'oscillations de l'élément optique (31; 1814) sont disposés.

**10.** Dispositif optique selon l'une quelconque des revendications 1 à 9, **caractérisé en ce que** la source de lumière (3 ; 1812) est un stroboscope, une source de lumière laser, un synchrotron, une source de lumière hachée, une source de lumière à commande électronique (lampe, diode), une source de lumière CW avec obturateur, ou une source de plasma.

**11.** Dispositif optique selon l'une quelconque des revendications 1 à 10, **caractérisé en ce que** l'élément optique (31 ; 1814) est une lame parallélépipédique, en particulier une membrane ou un miroir, ou bien se compose d'un liquide avec une surface réfléchissante, ou bien est une lentille, en particulier une lentille liquide.

**12.** Dispositif optique selon l'une quelconque des revendications 1 à 11, **caractérisé en ce que** les composants optiques individuels du réseau (1131; 1231 ; 1331 ; 1431) comprennent en particulier des lentilles, miroirs, grilles et/ou segments de lentilles plats en particulier à faces planes et parallèles, à réfringence par sections et/ou zones, les composants optiques individuels pouvant présenter des géométries identiques ou des géométries différentes.

**13.** Dispositif optique selon l'une quelconque des revendications 1 à 12, **caractérisé en ce que** les composants optiques individuels du réseau (1131 ; 1231 ; 1331 ; 1431) sont connectés ensemble à l'aide d'éléments de connexion (1163 ; 1363 ; 1463), au moins deux éléments de connexion (1163 ; 1363 ; 1463) présentant des propriétés d'élasticité différentes.

**14.** Dispositif optique selon l'une quelconque des revendications 1 à 13, **caractérisé en ce que** le dispositif optique (1 ; 1810) présente au moins deux éléments optiques (2152, 2154) espacés l'un de l'autre, entre lesquels un espace intermédiaire (2158) avec du gaz ou du liquide est disposé, de préférence au moins l'un des deux éléments optiques (2152, 2154), les deux éléments optiques (2152, 2154) et/ou l'espace intermédiaire (2158) pouvant être excités avec du gaz ou du liquide pour donner une oscillation, et/ou de préférence un premier élément optique parmi les deux éléments optiques (2152, 2154) étant réalisé de manière isolante électriquement et un deuxième élément optique parmi les deux éléments optiques (2152, 2154) étant réalisé de manière électroconductrice.

**15.** Dispositif optique selon l'une quelconque des revendications 1 à 14, **caractérisé en ce que** le dispositif optique (1 ; 1810) présente une unité de contrôle (35), laquelle comprend un système de mesure, un système d'évaluation et un système de contrôle, le système de mesure comprenant de préférence un ou plusieurs capteurs de focalisation, un interféromètre avec un éclairage cadencé, une unité de mesure de polarisation ou un dispositif avec des microphones ou des capteurs d'accélération pour mesurer des paramètres de contrôle de l'élément optique, et/ou le système de mesure comprenant de préférence un capteur de front d'onde, en particulier un interféromètre avec plusieurs canaux de mesure travaillant en parallèle pour la mesure synchrone au niveau de plusieurs points du champ, pour mesurer des paramètres de contrôle de l'ensemble du dispositif optique, et/ou le système de mesure comprenant de préférence un capteur polarimétrique avec des canaux de mesure travaillant en parallèle pour la mesure synchrone de l'état de polarisation du champ d'ondes lumineuses au niveau de plusieurs points du champ, afin de déterminer les paramètres de contrôle pour l'ensemble du dispositif optique, et/ou le système de contrôle comprenant de préférence un système de synchronisation pour la synchronisation de la fréquence d'oscillation de l'oscillation de l'élément optique avec la fréquence d'impulsion de la source de lumière.

16. Dispositif optique selon l'une quelconque des revendications 1 à 15, **caractérisé en ce que** le dispositif optique (1 ; 1810) contient au moins un autre élément optique manipulable, lequel est en particulier réalisé de manière à pouvoir coulisser, basculer ou se déformer statiquement.

# FIG.1

## FIG.2

233

231

## FIG.3

333

332

331

# FIG.4

# FIG.5

# FIG.6

631

633

641

**FIG.7**

**FIG.8**

**FIG.9**

**FIG.10**

1033    1031

1033

**FIG.11**

1163    1131

1161    1163

**FIG.12**

1261    1231

1265

## FIG.13

## FIG.14

## FIG.15

# FIG.16

# FIG.17

Fig.18

Fig.19

Fig.20

Fig.21

Fig.22

Fig.23

Fig.24

Fig.25

Fig.26A

Fig.26B

2173

2170

2172

R

r

## Fig.27A

Δn

r

## Fig.27B

## IN DER BESCHREIBUNG AUFGEFÜHRTE DOKUMENTE

**In der Beschreibung aufgeführte Patentdokumente**

- US 4970546 A
- US 20030063268 A1
- DE 19859634 A1
- EP 678768 A2
- US 6198579 B
- US 6521877 B
- US 6268903 B
- WO 02093257 A
- US 6700952 B2
- WO 02093257 A2
- DE 10040813 A1